(19) **Europäisches Patentamt**
**European Patent Office**
**Office européen des brevets**

(11) **EP 3 936 979 A1**

(12) **EUROPEAN PATENT APPLICATION**
published in accordance with Art. 153(4) EPC

(43) Date of publication:
**12.01.2022 Bulletin 2022/02**

(51) Int Cl.:
**G06F 3/01** (2006.01)    **G06F 1/16** (2006.01)

(21) Application number: **20795817.4**

(86) International application number:
**PCT/CN2020/085273**

(22) Date of filing: **17.04.2020**

(87) International publication number:
**WO 2020/216137 (29.10.2020 Gazette 2020/44)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **25.04.2019  CN 201910340125**

(71) Applicant: **Huawei Technologies Co., Ltd.**
**Shenzhen, Guangdong 518129 (CN)**

(72) Inventor: **XING, Zengping**
**Shenzhen, Guangdong 518129 (CN)**

(74) Representative: **Maiwald Patent- und Rechtsanwaltsgesellschaft mbH**
**Elisenhof**
**Elisenstraße 3**
**80335 München (DE)**

(54) **TOUCH KEY ASSEMBLY, CONTROL CIRCUIT AND ELECTRONIC DEVICE**

(57)    A touch key assembly, a control circuit, and an electronic device are provided, to reduce power consumption. The electronic device includes a sensor (300) and a control circuit (400). The sensor (300) is configured to: detect a force or a deformation of a shell (10), and output a force sensing signal $S_f$. The control circuit is configured to: receive the force sensing signal $S_f$ and determine, based on the force sensing signal $S_f$, whether to send a drive signal $S_d$ to the sensor (300). The drive signal $S_d$ is used to drive the sensor (300) to drive the shell (10) to vibrate. The sensor (300) is further configured to: detect vibration of the shell (10) and output a vibration sensing signal $S_z$. The control circuit (400) is further configured to: receive the vibration sensing signal $S_z$, and determine, based on the vibration sensing signal $S_z$, whether to trigger an event.

<u>200</u>

FIG. 8

EP 3 936 979 A1

**Description**

This application claims priority to Chinese Patent Application No. 201910340125.1, filed with China National Intellectual Property Administration on April 25, 2019 and entitled "TOUCH KEY ASSEMBLY, CONTROL CIRCUIT, AND ELECTRONIC DEVICE", which is incorporated herein by reference in its entirety.

**TECHNICAL FIELD**

This application relates to the field of electronic products, and in particular, to a touch key assembly, a control circuit, and an electronic device.

**BACKGROUND**

With development of mobile device technologies, integration will become a trend. This has great advantages in terms of waterproofing and user experience. As a barrier to integration of mobile devices, physical keys will gradually be replaced by virtual keys. However, virtual keys also have many problems to be resolved. For example, the virtual keys are easily false-triggered by a user, and input costs of industrial mass production of devices need to be considered. How to implement a virtual key with false trigger resistance, low power consumption, and high performance is a problem that urgently needs to be resolved in the industry.

**SUMMARY**

This application provides a touch key assembly, a control circuit, and an electronic device, to effectively resist false trigger and reduce power consumption of the touch key assembly.

According to a first aspect, an electronic device is provided, including a sensor and a control circuit. The sensor is configured to: detect a force or a deformation of a shell, and output a force sensing signal $S_f$. The control circuit is configured to: receive the force sensing signal $S_f$ and determine, based on the force sensing signal $S_f$, whether to send a drive signal $S_d$ to the sensor. The drive signal $S_d$ is used to drive the sensor to drive the shell to vibrate. The sensor is further configured to: detect vibration of the shell and output a vibration sensing signal $S_z$. The control circuit is further configured to: receive the vibration sensing signal $S_z$, and determine, based on the vibration sensing signal $S_z$, whether to trigger an event.

In the electronic device provided in this embodiment of this application, the sensor drives, by using the received drive signal $S_d$, the shell to vibrate, and outputs the vibration sensing signal $S_z$ in response to the vibration; and the control circuit determines, by detecting the vibration sensing signal $S_z$, whether to trigger an event. In addition, the control circuit further determines, by detecting the force sensing signal $S_f$ output by the sensor, whether to start to send the drive signal $S_d$. Therefore, the control circuit does not need to always send the drive signal $S_d$, so that power consumption is reduced when good false trigger resistance is implemented.

With reference to the first aspect, in a possible implementation of the first aspect, the control circuit is specifically configured to: detect and determine whether the force sensing signal $S_f$ satisfies an active action condition, and when the force sensing signal $S_f$ satisfies the active action condition, send the drive signal $S_d$ to the sensor.

With reference to the first aspect, in a possible implementation of the first aspect, the control circuit is specifically configured to: detect and determine whether the force sensing signal $S_f$ satisfies a condition for starting calculation, and when the force sensing signal $S_f$ satisfies the condition for starting calculation, calculate, based on the force sensing signal $S_f$, a force and/or an accelerating force sensed by the sensor; and determine whether the force and/or the accelerating force satisfy/satisfies the active action condition, and when the force and/or the accelerating force satisfy/satisfies the active action condition, send the drive signal $S_d$ to the sensor.

In this embodiment of this application, the control circuit starts calculating the force and/or the accelerating force only when the force sensing signal $S_f$ reaches a preset condition. Therefore, the control circuit does not need to always perform a function of calculating the force and/or the accelerating force, so that power consumption can be reduced.

With reference to the first aspect, in a possible implementation of the first aspect, the control circuit is specifically configured to: when the force sensing signal $S_f$ satisfies a condition for starting calculation, start an interrupt program; and after the interrupt program is started, calculate, based on the force sensing signal $S_f$, a force and/or an accelerating force sensed by the sensor, and determine whether the force and/or the accelerating force satisfy/satisfies the active action condition, and when the force and/or the accelerating force satisfy/satisfies the active action condition, send the drive signal $S_d$ to the sensor.

In this embodiment of this application, the control circuit includes an interrupt circuit. The control circuit starts calculating the force and/or the accelerating force only when entering the interrupt program. Therefore, the control circuit does not need to always perform a function of calculating the force and/or the accelerating force, so that power consumption can be reduced.

With reference to the first aspect, in a possible implementation of the first aspect, the control circuit includes a first amplification unit, and the first amplification unit is configured to amplify the vibration sensing signal Sz.

In this embodiment of this application, the control circuit amplifies the vibration sensing signal $S_z$ output by the sensor, to help determine, more precisely and sensitively, whether to trigger an event, thereby improving sensitivity and false trigger resistance of the electronic device.

With reference to the first aspect, in a possible implementation of the first aspect, the control circuit further includes a second amplification unit, configured to amplify the force sensing signal $S_f$.

In this embodiment of this application, the control circuit amplifies the force sensing signal $S_f$ output by the sensor, to help determine, more precisely and sensitively, whether to trigger an event, thereby improving sensitivity and false trigger resistance of the electronic device.

With reference to the first aspect, in a possible implementation of the first aspect, the control circuit further includes a filter unit, configured to filter the vibration sensing signal $S_z$.

With reference to the first aspect, in a possible implementation of the first aspect, the sensor includes a first port A, a second port B, and a third port E; the first port A is configured to: receive the drive signal $S_d$ and output the force sensing signal $S_f$, the second port B is configured to output the vibration sensing signal $S_z$, and the third port E is a common end.

With reference to the first aspect, in a possible implementation of the first aspect, the sensor includes a first port A, a second port B, and a third port E; the first port A is configured to receive the drive signal $S_d$, the second port B is configured to output the vibration sensing signal $S_z$ and the force sensing signal $S_f$, and the third port E is a common end.

With reference to the first aspect, in a possible implementation of the first aspect, the control circuit is a processing chip of the electronic device.

With reference to the first aspect, in a possible implementation of the first aspect, the control circuit is a control chip of the sensor.

With reference to the first aspect, in a possible implementation of the first aspect, the shell is a part of a housing of the electronic device.

With reference to the first aspect, in a possible implementation of the first aspect, the shell is a shell of the sensor.

According to a second aspect, a control circuit is provided. The control circuit is configured to receive a force sensing signal $S_f$ output by a sensor. The force sensing signal $S_f$ is used to indicate a force or a deformation detected by the sensor. The control circuit is further configured to determine, based on the force sensing signal $S_f$, whether to send a drive signal $S_d$ to the sensor. The drive signal $S_d$ is used to drive the sensor to vibrate. The control circuit is further configured to: receive a vibration sensing signal $S_z$ sent by the sensor, and determine, based on the vibration sensing signal $S_z$, whether to trigger an event. The vibration sensing signal $S_z$ is a response signal of the vibration.

In the control circuit provided in this embodiment of this application, the control circuit determines, by detecting the force sensing signal $S_f$ output by the sensor, whether to start to send the drive signal $S_d$. Therefore, the control circuit does not need to always send the drive signal $S_d$ to the sensor to drive the sensor to vibrate, so that power consumption is reduced.

With reference to the second aspect, in a possible implementation of the second aspect, the control circuit is specifically configured to: detect and determine whether the force sensing signal $S_f$ satisfies an active action condition, and when the force sensing signal $S_f$ satisfies the active action condition, send the drive signal $S_d$ to the sensor.

With reference to the second aspect, in a possible implementation of the second aspect, the control circuit is specifically configured to: detect and determine whether the force sensing signal $S_f$ satisfies a condition for starting calculation, and when the force sensing signal $S_f$ satisfies the condition for starting calculation, calculate, based on the force sensing signal $S_f$, a force and/or an accelerating force sensed by the sensor; and determine whether the force and/or the accelerating force satisfy/satisfies the active action condition, and when the force and/or the accelerating force satisfy/satisfies the active action condition, send the drive signal $S_d$ to the sensor.

With reference to the second aspect, in a possible implementation of the second aspect, the control circuit is specifically configured to: when the force sensing signal $S_f$ satisfies a condition for starting calculation, start an interrupt program; and after the interrupt program is started, calculate, based on the force sensing signal $S_f$, a force and/or an accelerating force sensed by the sensor, and determine whether the force and/or the accelerating force satisfy/satisfies the active action condition, and when the force and/or the accelerating force satisfy/satisfies the active action condition, send the drive signal $S_d$ to the sensor.

With reference to the second aspect, in a possible implementation of the second aspect, the control circuit includes a first amplification unit, and the first amplification unit is configured to amplify the vibration sensing signal $S_z$.

With reference to the second aspect, in a possible implementation of the second aspect, the control circuit further includes a second amplification unit, configured to amplify the force sensing signal $S_f$.

With reference to the second aspect, in a possible implementation of the second aspect, the control circuit further includes a filter unit, configured to filter the vibration sensing signal $S_z$.

With reference to the second aspect, in a possible implementation of the second aspect, the control circuit and the sensor are disposed in an electronic device, and the control circuit is located in a processing chip of the electronic device.

With reference to the second aspect, in a possible implementation of the second aspect, the control circuit is a control chip of the sensor.

According to a third aspect, a touch key assembly is provided, including a sensor, a shell, and the control circuit in the second aspect or any possible manner of the second aspect. The sensor is configured to detect a force or a deformation of the shell, and the drive signal $S_d$ is used to drive the sensor to drive the shell to vibrate.

According to a fourth aspect, an electronic device is provided, including the touch key assembly in the third aspect. The shell and a housing of the electronic device are attached to each other or are integrated into an entire body.

According to a fifth aspect, a control method applied to an electronic device is provided. A sensor of the electronic device is attached to a shell. The method includes: detecting a force or a deformation of the shell; driving the shell to vibrate when the force or the deformation satisfies an active action condition; and determining to trigger an event when a vibration characteristic of the shell falls within a range of user trigger habits.

With reference to the fifth aspect, in a possible implementation of the fifth aspect, the shell is a shell of the electronic device, and the detecting a force or a deformation of the shell is specifically detecting a force or a deformation of a shell of the electronic device.

With reference to the fifth aspect, in a possible implementation of the fifth aspect, the shell is a shell of the sensor, and the detecting a force or a deformation of the shell is specifically detecting a force or a deformation of a shell of the sensor.

According to a sixth aspect, a chip is provided. The chip includes the control circuit in the second aspect or any implementation of the second aspect.

According to a seventh aspect, an electronic device is provided, including a sensor and a control circuit. The sensor includes a drive unit, a vibration sensing unit, and a force sensing unit. The drive unit is configured to: receive a drive signal $S_d$ and drive a shell to vibrate. The vibration sensing unit is configured to: detect vibration of the shell and output a vibration sensing signal $S_z$. The force sensing unit is configured to: detect a force or a deformation, and output a force sensing signal $S_f$. The control circuit is configured to: detect the force sensing signal $S_f$, and determine, based on the force sensing signal $S_f$, whether to send the drive signal $S_d$ to the drive unit. The control circuit is further configured to: detect the vibration sensing signal $S_z$, and determine, based on the vibration sensing signal $S_z$, whether to trigger an event.

With reference to the seventh aspect, in a possible implementation of the seventh aspect, the control circuit includes a calculation unit, a signal generation unit, and a detection unit. The calculation unit is configured to: detect and determine whether the force sensing signal $S_f$ satisfies an active action condition, and when the force sensing signal $S_f$ satisfies the active action condition, send an indication signal to the signal generation unit, where the indication signal is used to indicate to start the signal generation unit. The signal generation unit is configured to send the drive signal $S_d$ to the drive unit after receiving the indication signal. The detection unit is configured to: detect the vibration sensing signal $S_z$, and determine, based on the vibration sensing signal $S_z$, whether to trigger an event.

With reference to the seventh aspect, in a possible implementation of the seventh aspect, the control circuit further includes a first amplification unit. The first amplification unit is disposed between the vibration sensing unit and the detection unit, and is configured to amplify the vibration sensing signal $S_z$.

With reference to the seventh aspect, in a possible implementation of the seventh aspect, the control circuit further includes a second amplification unit. The second amplification unit is disposed between the force sensing unit and the calculation unit, and is configured to amplify the force sensing signal $S_f$.

With reference to the seventh aspect, in a possible implementation of the seventh aspect, the control circuit further includes a filter unit. The filter unit is disposed between the vibration sensing unit and the detection unit, and is configured to filter the vibration sensing signal $S_z$.

With reference to the seventh aspect, in a possible implementation of the seventh aspect, the calculation unit is specifically configured to: determine whether the force sensing signal $S_f$ satisfies a condition for starting calculation, and when the force sensing signal $S_f$ satisfies the condition for starting calculation, calculate, based on the force sensing signal $S_f$, a force and/or an accelerating force sensed by the sensor; and determine whether the force and/or the accelerating force satisfy/satisfies the active action condition, and when the force and/or the accelerating force satisfy/satisfies the active action condition, send the indication signal to the signal generation unit.

With reference to the seventh aspect, in a possible implementation of the seventh aspect, the control circuit further includes an interrupt unit. The interrupt unit is configured to: detect the force sensing signal $S_f$, and when the force sensing signal $S_f$ satisfies a condition for starting calculation, start the calculation unit. The calculation unit is configured to: calculate, based on the force sensing signal $S_f$, a force and/or an accelerating force sensed by the sensor;

and determine whether the force and/or the accelerating force satisfy/satisfies the active action condition, and when the force and/or the accelerating force satisfy/satisfies the active action condition, send the indication signal to the signal generation unit.

With reference to the seventh aspect, in a possible implementation of the seventh aspect, the control circuit further includes a third amplification unit. The third amplification unit is disposed between the interrupt unit and the force sensing unit, and is configured to amplify the force sensing signal $S_f$.

With reference to the seventh aspect, in a possible implementation of the seventh aspect, the drive unit and the vibration sensing unit are both piezoelectric devices. The force sensing unit reuses a piezoelectric device used as the drive unit or reuses a piezoelectric device used as the vibration sensing unit.

With reference to the seventh aspect, in a possible implementation of the seventh aspect, the drive unit is a piezoelectric device, and the vibration sensing unit is a piezoresistive device. The force sensing unit reuses a piezoelectric device used as the drive unit or reuses a piezoresistive device used as the vibration sensing unit.

With reference to the seventh aspect, in a possible implementation of the seventh aspect, the shell is a part of a housing of the electronic device.

With reference to the seventh aspect, in a possible implementation of the seventh aspect, the shell is a shell of the sensor.

According to an eighth aspect, a control circuit is provided. The control circuit includes: a calculation unit, configured to: receive a force sensing signal $S_f$ output by a sensor, and determine, based on the force sensing signal $S_f$, whether to send an indication signal to a signal generation unit, where the indication signal is used to indicate to start the signal generation unit, and the force sensing signal $S_f$ is used to indicate a force or a deformation detected by the sensor; the signal generation unit, configured to send a drive signal $S_d$ to the sensor after receiving the indication signal, where the drive signal $S_d$ is used to drive the sensor to vibrate; and a detection unit, configured to: receive a vibration sensing signal $S_z$ sent by the sensor, and determine, based on the vibration sensing signal $S_z$, whether to trigger an event, where the vibration sensing signal $S_z$ is a response signal of the vibration.

With reference to the eighth aspect, in a possible implementation of the eighth aspect, the calculation unit is specifically configured to: detect and determine whether the force sensing signal $S_f$ satisfies an active action condition, and when the force sensing signal $S_f$ satisfies the active action condition, send the indication signal to the signal generation unit.

With reference to the eighth aspect, in a possible implementation of the eighth aspect, the control circuit further includes a first amplification unit. The first amplification unit is disposed between the vibration sensing unit and the detection unit, and is configured to amplify the vibration sensing signal $S_z$.

With reference to the eighth aspect, in a possible implementation of the eighth aspect, the control circuit further includes a second amplification unit. The second amplification unit is disposed between the force sensing unit and the calculation unit, and is configured to amplify the force sensing signal $S_f$.

With reference to the eighth aspect, in a possible implementation of the eighth aspect, the control circuit further includes a filter unit. The filter unit is disposed between the vibration sensing unit and the detection unit, and is configured to filter the vibration sensing signal $S_z$.

With reference to the eighth aspect, in a possible implementation of the eighth aspect, the calculation unit is specifically configured to: determine whether the force sensing signal $S_f$ satisfies a condition for starting calculation, and when the force sensing signal $S_f$ satisfies the condition for starting calculation, calculate, based on the force sensing signal $S_f$, a force and/or an accelerating force sensed by the sensor; and determine whether the force and/or the accelerating force satisfy/satisfies the active action condition, and when the force and/or the accelerating force satisfy/satisfies the active action condition, send the indication signal to the signal generation unit.

With reference to the eighth aspect, in a possible implementation of the eighth aspect, the control circuit further includes an interrupt unit. The interrupt unit is configured to: detect the force sensing signal $S_f$, and when the force sensing signal $S_f$ satisfies a condition for starting calculation, start the calculation unit. The calculation unit is specifically configured to: calculate, based on the force sensing signal $S_f$, a force and/or an accelerating force sensed by the sensor; and determine whether the force and/or the accelerating force satisfy/satisfies the active action condition, and when the force and/or the accelerating force satisfy/satisfies the active action condition, send the indication signal to the signal generation unit.

With reference to the eighth aspect, in a possible implementation of the eighth aspect, the control circuit further includes a third amplification unit. The third amplification unit is disposed between the interrupt unit and the force sensing unit, and is configured to amplify the force sensing signal $S_f$.

With reference to the eighth aspect, in a possible implementation of the eighth aspect, the drive unit and the vibration sensing unit are both piezoelectric devices. The force sensing unit reuses a piezoelectric device used as the drive unit or reuses a piezoelectric device used as the vibration sensing unit.

With reference to the eighth aspect, in a possible implementation of the eighth aspect, the drive unit is a piezoelectric device, and the vibration sensing unit is a piezoresistive device. The force sensing unit reuses a piezoelectric device used as the drive unit or reuses a piezoresistive device used as the vibration sensing unit.

According to a ninth aspect, a touch key assembly is provided, including a sensor, a shell, and the control circuit in the eighth aspect or any implementation of the eighth aspect. A drive signal $S_d$ is used to drive the sensor to drive the shell to vibrate.

According to a tenth aspect, an electronic device is provided, including the touch key assembly in the ninth aspect. The shell and a housing of the electronic device are attached to each other or are integrated into an entire body.

According to an eleventh aspect, a chip is provided. The chip includes the control circuit in the eighth aspect or any implementation of the eighth aspect.

## BRIEF DESCRIPTION OF DRAWINGS

FIG. 1 is a schematic structural diagram of an electronic device to which an embodiment of this application may be applied;

FIG. 2 is a schematic diagram of false-triggering a key by a user according to an embodiment of this application;

FIG. 3 is a schematic structural diagram of a touch key assembly according to an embodiment of this application;

FIG. 4(a) and FIG. 4(b) are schematic diagrams of relative positions of an electronic device and a sensor according to an embodiment of this application;

FIG. 5 is a schematic structural diagram of a touch key assembly according to another embodiment of this application;

FIG. 6 is a schematic diagram of vibration of a touch key assembly when no touch force is applied to the touch key assembly according to an embodiment of this application;

FIG. 7 is a schematic diagram of vibration of a touch key assembly when a touch force is applied to the touch key assembly according to an embodiment of this application;

FIG. 8 is a schematic structural diagram of a touch key assembly according to another embodiment of this application;

FIG. 9 is a schematic structural diagram of a touch key assembly according to another embodiment of this application;

FIG. 10 is a flow block diagram of determining, by a touch key assembly, whether to trigger an event according to an embodiment of this application;

FIG. 11 is a schematic structural diagram of a touch key assembly according to another embodiment of this application;

FIG. 12 is a schematic structural diagram of a touch key assembly according to another embodiment of this application;

FIG. 13 is a circuit schematic diagram of a touch key assembly according to another embodiment of this application;

FIG. 14 is a schematic structural diagram of a "piezoelectric input/piezoelectric output"-type sensor according to an embodiment of this application;

FIG. 15 is a circuit schematic diagram of a touch key assembly according to another embodiment of this application;

FIG. 16 is a flow block diagram of determining, by a touch key assembly, whether to trigger an event according to another embodiment of this application;

FIG. 17 is a schematic structural diagram of a touch key assembly according to another embodiment of this application;

FIG. 18 is a circuit schematic diagram of a touch key assembly according to another embodiment of this application;

FIG. 19 is a flowchart of determining, by a touch key assembly, whether to trigger an event according to another embodiment of this application;

FIG. 20 is a circuit schematic diagram of a touch key assembly according to another embodiment of this application;

FIG. 21 is a schematic structural diagram of a "piezoelectric input/piezoresistive output"-type sensor according to an embodiment of this application;

FIG. 22 is a circuit schematic diagram of a touch key assembly according to another embodiment of this application;

FIG. 23 is a schematic structural diagram of a "piezoelectric input/piezoelectric output"-type sensor according to another embodiment of this application; and

FIG. 24 is a schematic structural diagram of a "piezoelectric input/piezoresistive output"-type sensor according to another embodiment of this application.

## DESCRIPTION OF EMBODIMENTS

The following describes technical solutions of this application with reference to the accompanying drawings.

Embodiments of this application relate to a touch key assembly and an apparatus, which may be applied to an electronic device. The electronic device may include a terminal device, a mobile terminal, a wearable electronic device, a household appliance, an automobile dashboard, or another electrical product, for example, a smartphone, a tablet computer, or a smartwatch.

The touch key assembly in this application may also be referred to as a virtual key. Application of the virtual key is of great significance for improving user experience and waterproofing. However, the virtual key is easily false-triggered, and such false trigger causes relatively poor user experience, limiting development of a virtual key technology on a terminal device such as a smartphone or a tablet computer. In addition, good force perception can enable a user to have good experience of a trigger response, and how to design a cheap and reliable virtual key to respond well to a force from the user and reduce false triggers is a current development direction of the virtual key.

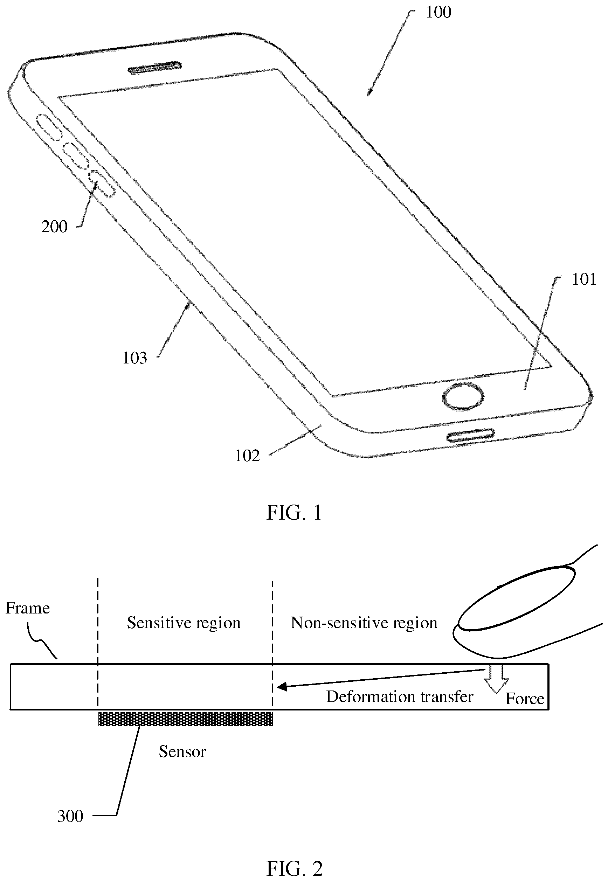

FIG. 1 is a schematic structural diagram of an electronic device 100 to which an embodiment of this application may be applied. As shown in FIG. 1, a housing of the electronic device 100 includes a front panel 101, a middle frame 102, and a rear cover 103. Generally, a touch key assembly may be disposed at a position of the housing or a touchscreen of the electronic device 100, for example, a position of the front panel 101, the middle frame 102, or the rear cover 103. The touch key assembly may be disposed on an outer side wall or an inner side wall of the housing of the electronic device 100. The touch key assembly in FIG. 1 is disposed on an outer side frame of the middle frame 102, and is represented by using a dashed-line box. During actual application, a marked symbol may be disposed on an outer surface of the electronic device 100, to prompt a position at which a user triggers the touch key assembly, or a transparent region, a euphotic region, a convex portion, or a concave portion may be disposed on the housing of the electronic device 100, where the touch key assembly is disposed inside. Alternatively, the touch key assembly may be made into a module form, and is attached to the housing of the electronic device 100. The touch key assembly in this application may implement a function of a general physical key (or in other words, a mechanical key), for example, a function key such as a volume adjustment key, an OK key, a power key, a sliding keypad, or a press key.

FIG. 2 is a schematic diagram of false-triggering a touch key assembly by a user according to an embodiment of this application. FIG. 2 shows only a sensor 300 of the touch key assembly, and does not show a control circuit of the touch key assembly. As shown in FIG. 2, an outer surface of an electronic device includes a sensitive region and a non-sensitive region. The sensor 300 of the touch key assembly may be disposed at an inner wall position corresponding to the sensitive region. The non-sensitive region is a region adjacent to the sensitive region. In an ideal case, the sensor 300 of the electronic device detects a deformation only when the user touches the sensitive region, to indicate that the user triggers the touch key assembly. When the user touches a region other than the sensitive region, the sensor 300 of the electronic device does not detect a deformation, and does not indicate that the user triggers the touch key assembly. Therefore, the electronic device does not make misjudgment. However, during actual application, the touch key assembly is easily false-triggered, for example, false-triggered by another object other than a human body, or a key is false-triggered when the user touches the non-sensitive region. This false trigger is caused by the following reasons: Most sensors measure only a deformation, that is, sense a force/deformation. A deformation in the non-sensitive region is easily transferred to the sensitive region, leading to a deformation in the sensitive region. When the sensor detects the deformation, it is considered that the sensitive region is touched, leading to false trigger. A deformation caused by a vibration feedback (for example, motor vibration in the device) may also cause the sensor to trigger falsely.

To eliminate impact of false trigger, one manner is to resist false trigger by changing a structure, for example, by increasing a thickness of a side edge, so that deformations outside the non-sensitive region and deformations transferred to the sensitive region are reduced. However, this manner is contradictory to a development trend of thinning mobile devices, and is prone to poor user experience due to inconsistent touch forces. Another manner is to make the sensitive region have some feature identification codes, such as fingerprint recognition. However, this manner causes relatively high costs. In addition, adding a fingerprint recognition function slows down a response speed of a key, affecting user experience. Therefore, how to manufacture a virtual key with good false trigger resistance is a hot topic in the industry.

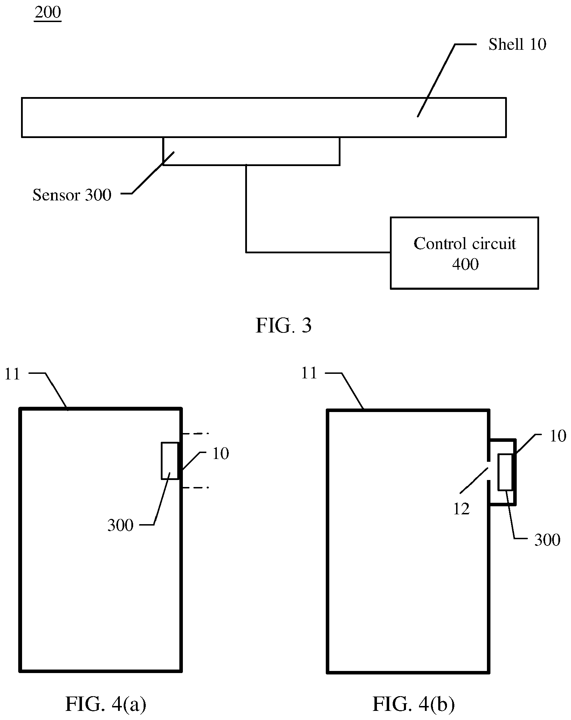

FIG. 3 is a schematic structural diagram of a touch key assembly according to an embodiment of this application. As shown in FIG. 3, the touch key assembly includes a sensor 300 and a control circuit 400. The sensor 300 is attached to a shell 10. Optionally, the shell 10 may be a part of a housing of an electronic device. In other words, the shell 10 and the housing of the electronic device are an integrated structure. For example, as shown in FIG. 4(a), the sensor 300 may be attached to an inner surface of the housing 11 of the electronic device. Alternatively, the shell 10 and the housing 11 of the electronic device may be discrete structures. For example, the shell 10 may be a shell of the sensor 300. In this case, the sensor 300 may be attached to an outer surface of the housing 11 of the electronic device. The shell 10 touched by a user is the shell of the sensor 300, rather than the housing of the electronic device. For example, as shown in FIG. 4(b), a through hole 12 may be provided in the housing 11 of the electronic device. The sensor 300 is attached to the outer surface of the housing 11 of the electronic device. If the control circuit 400 is disposed inside the electronic device, a connection between the sensor 300 and the control circuit 400 may be implemented by using the through hole 12. If the control circuit 400 and the sensor 300 are both packaged in the shell 10, the control circuit 400 may implement a connection to a processing chip inside the electronic device by using the through hole 12. In another example, a concave portion may be disposed on the outer surface of the housing 11 of the electronic device, and the sensor 300 is disposed in the concave portion, to make a height of the sensor 300 consistent with a height of the surface of the housing of the electronic device. A person skilled in the art can understand that, a position relationship between the touch key assembly and the electronic device may alternatively have other implementations, which are not listed one by one in this application.

The sensor 300 is configured to: sense a touch force generated by the user or another object on the shell 10, and generate a corresponding sensing signal. The control circuit 400 detects the sensing signal sent by the sensor 300. The control circuit 400 may determine, based on the foregoing sensing signal, whether to trigger an event. Triggering an event may refer to triggering a function corresponding to the touch key assembly. For example, if the touch key assembly corresponds to a power key, a power-on function is triggered. If the touch key assembly corresponds to volume adjustment, a function of volume adjustment is triggered. Optionally, the touch key assembly may also be referred to as a touch sensing module, a virtual key, or the like.

In an implementation, the touch key assembly may be implemented by using a high-frequency vibration damping suppression method. The method is also referred to as an active method. A principle of the active method lies in that the control circuit 400 outputs a drive signal $S_d$ of a particular frequency to the sensor 300, and the drive signal $S_d$ enables the sensor 300 to drive the shell 10 to vibrate. A structure in which the sensor 300 and the shell 10 are combined together may be referred to as a composite resonator. The frequency of the foregoing drive signal $S_d$ may be the same as or similar to a resonance frequency of the composite resonator. The control circuit 400 detects a vibration sensing signal $S_z$ that is in response to the foregoing vibration and that is output by the sensor 300. If the user touches or presses a region in which the touch key assembly is located, amplitude of the vibration sensing signal $S_z$ output by the sensor 300 attenuates or increases. The control circuit 400 may determine, by determining a degree of attenuation or increase of the vibration sensing signal $S_z$, whether to trigger an event. This determining manner is Boolean judgment. This manner can effectively resist non-human-body false trigger, and has advantages of low costs and high sensitivity.

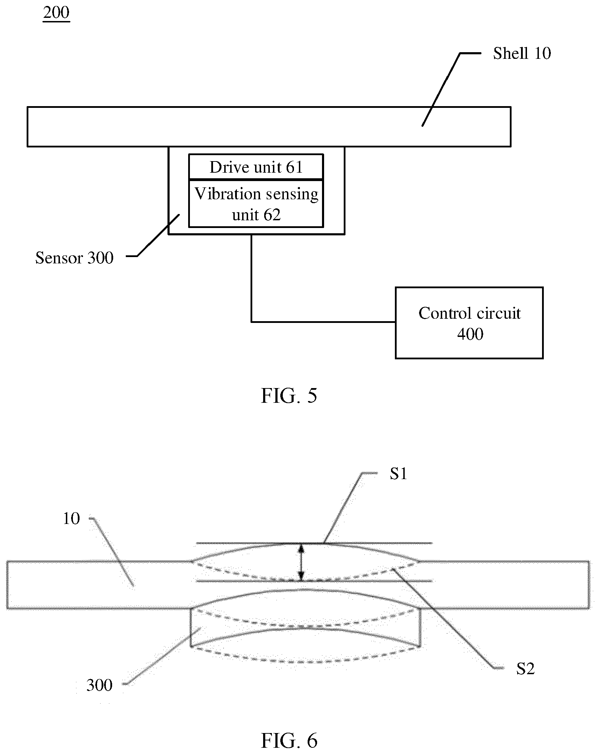

FIG. 5 is a schematic structural diagram of a touch key assembly according to another embodiment of this application. As shown in FIG. 5, a sensor 300 includes a drive unit 61 and a vibration sensing unit 62. The drive unit 61 is configured to: receive a drive signal $S_d$ input by a control circuit 400, and drive a shell 10 to vibrate. The vibration sensing unit 62 is configured to: sense the foregoing vibration, and output a vibration sensing signal $S_z$. The drive unit 61 may be a device of any one of the following types: a piezoelectric device, a magnetomechanical device, an electric device, and a thermoelectric device. The vibration sensing unit 62 may be a device of any one of the following types: a piezoelectric device, a piezoresistive device, a piezocapacitive device, and a piezoinductive device. In this application, specific structures of the drive unit 61 and the vibration sensing unit 62 include a plurality of implementations. For example, the drive unit 61 may be of a piezo sheet structure or a drive structure including a magnetic piece and a coil, and the vibration sensing unit 62 may include a piezo sheet structure or a piezoresistive material. This application is not limited to the illustrated architecture. Provided that the drive unit 61 can generate vibration and drive the shell to vibrate, and the vibration sensing unit 62 can detect vibration amplitude of the shell, they both fall within the scope of this application.

Optionally, the vibration sensing signal $S_z$ detected by the control circuit 400 may be a response signal when the sensor 300 receives the drive signal $S_d$, or may be a coda wave response signal after the sensor 300 receives the drive signal $S_d$. This is not limited in this application. The control circuit 400 may determine, based on whether the vibration sensing signal $S_z$ matches a trigger characteristic of human body, whether to trigger an event. If the vibration sensing signal $S_z$ matches the trigger characteristic of human body, the control circuit 400 determines to trigger an event. If the vibration sensing signal $S_z$ does not match the trigger characteristic of human body, the current detection is discarded. Next, a specific manner of determining whether the vibration sensing signal $S_z$ matches the trigger characteristic of human body is described.

Still refer to FIG. 5. The control circuit 400 may compare the vibration sensing signal $S_z$ generated by the vibration sensing unit 62 with a threshold, and determine, based on a comparison result, whether to trigger an event. The threshold is a boundary value of a range that matches user touch habits, and when the comparison result shows that the vibration sensing signal $S_z$ falls within the range that matches user touch habits, the control circuit 400 determines to trigger an event. The "boundary value" may be an upper limit or a lower limit of the range that matches user touch habits, and the reason lies in that: When the user presses a virtual key, a touch force of the user may cause a decrease in the vibration amplitude of the shell 10 or an increase in the vibration amplitude of the shell 10. In other words, the touch force of the user may suppress the vibration of the shell 10, or may increase the vibration amplitude of the shell 10. When the touch force of the user suppresses the vibration of the shell 10, the threshold is the upper limit of the range that matches user touch habits. When the touch force of the user increases the vibration amplitude of the shell 10, the threshold is the lower limit of the range that matches user touch habits.

The vibration sensing signal $S_z$ is used to represent the vibration amplitude of the shell 10. The vibration sensing signal $S_z$ may be a voltage signal, or may be a resistance/capacitance/inductance value variation. This is related to specific design forms of the drive unit 61 and the vibration sensing unit 62. Correspondingly, the range that matches user touch habits refers to an amplitude range related to a vibration region of the shell 10 after forces are applied to the vibration region of the shell 10 by habits of triggering the virtual key by the user. Matching user touch habits refers to satisfying touch feelings of a user. The range that matches user touch habits is range values obtained by collecting and sampling data based on different habits of user touch feelings, and collecting statistics on and analyzing the data. For example, the range of user touch habits may be collected and obtained in a machine learning manner, and ranges of user touch habits of different users may be different.

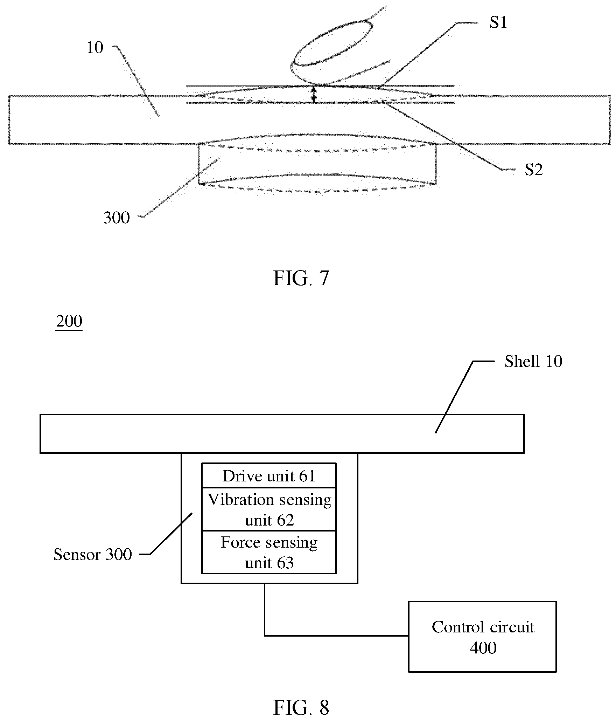

In an implementation, amplitude of vibration generated by driving the shell 10 by the drive unit 61 when no touch force is applied to the shell 10 falls within a first range. FIG. 6 is a schematic diagram of vibration of the shell 10 under driving by the drive unit 61 when no touch force is applied to the shell 10, and includes two states of maximum displacement in a vibration process, respectively represented by a solid line (SI) and a dotted line (S2). When a touch force is applied to an outer surface of the shell 10, as shown in FIG. 7, the user touches the shell 10 by using a finger, and the vibration of the shell 10 is suppressed under the action of the force generated by finger touch of the user. The vibration amplitude of the shell 10 shown in FIG. 7 is less than that of the shell 10 shown in FIG. 6. Certainly, in some vibration frequency states, the vibration amplitude of the shell 10 becomes larger. To be specific, the touch key assembly in this application is used, and the action of the touch force on the shell 10 may also increase the vibration amplitude of the shell 10.

The control circuit 400 receives the vibration sensing signal $S_z$, and determines, based on a result of comparison between the vibration sensing signal $S_z$ and the threshold, whether to trigger an event. When the touch force applied to the shell 10 suppresses vibration of the shell 10, the threshold is less than a lower limit of the first range. When amplitude of the vibration sensing signal $S_z$ is less than the threshold, the control circuit 400 determines to trigger an event. When the touch force applied to the shell 10 increases the vibration amplitude of the shell 10, the threshold is greater than the upper limit of the first range. When the amplitude of the vibration sensing signal $S_z$ is greater than the threshold, the control circuit 400 determines to trigger an event. Data of the first range is affected by factors such as a temperature and a material of an electronic device in which the touch key assembly is located. After a plurality of tests, the vibration amplitude that is in a case in which the user does not apply a touch force and that is obtained through statistics collection may be a voltage signal or a resistance variation. Setting of the first range may be performed by a primary chip integrated in the electronic device or a circuit in a processor, or may be performed by a hardware circuit independent of the primary chip or the processor.

This application provides a touch key assembly, in which the drive unit 61 of the sensor drives the shell 10 to vibrate, and the vibration sensing unit 62 detects the vibration amplitude of the shell 10. When there is a touch force, the vibration of the shell 10 is suppressed or the vibration amplitude of the shell 10 is increased. The virtual key is implemented by comparing, by using the control circuit 400, a relationship between the detected vibration amplitude and the threshold.

The first range is an amplitude range of the vibration of the shell 10 driven by the drive unit 61 when no touch force is applied to the shell 10. When the shell 10 is not subject to any environmental interference, and no touch force is applied to the shell 10, the amplitude of the vibration of the shell 10 driven by the drive unit 61 should be a value. However, a mobile terminal is inevitably affected by some environmental factors, such as a temperature change, different materials of the shell 10, and a user state change (for example, the vibration amplitude of the shell 10 is affected by factors, such as the mobile terminal being located in a pocket of the user, the user processing a still state and a moving state, or a change such as contact or friction between the mobile terminal and the user). Due to impact of these environmental factors, the amplitude range of the vibration of the shell 10 driven by the drive unit 61 when no touch force is applied to the shell 10 is defined as the first range. The first range is set through a plurality of tests, and is the vibration amplitude that is in a case in which the user does not apply a touch force and that is obtained through statistics collection, and the vibration amplitude may be identified by using a voltage signal or a resistance variation.

It can be learned based on user experience or experimental data that: it is relatively appropriate to use that the threshold is less than a lower limit of the first range or greater than an upper limit of the first range as a condition for determining, by the control circuit, to trigger an event, so that accurate judgment can be obtained, and trigger accuracy and reliability of the touch key assembly are improved. In an implementation, the threshold is 0.1 to 0.9 times the lower limit of the first range, or the threshold is greater than or equal to 1.1 times the upper limit of the first range.

Optionally, in this application, a buffer structure is disposed on an inner surface of the shell 10, so that the vibration generated by the sensor 300 is concentrated in a region in which the drive unit 61 and/or the vibration sensing unit 62 are/is attached to the shell 10, and the vibration is prevented from being diffused to other regions of the shell 10. When a touch force is applied to a position of the vibration of the shell, impact of false trigger in the other regions of the shell 10 on the touch key assembly can be prevented. Because the other regions of the shell 10 are not affected by the vibration of the drive unit, when a touch force is applied to the other regions of the shell 10, the amplitude of the vibration of the shell driven by the drive unit is not suppressed or increased, and the key is not triggered naturally, thereby improving sensitivity and false trigger resistance of the key.

In the foregoing implementation, the control circuit 400 needs to output a drive signal $S_d$ to the sensor 300 frequently (for example, usually at a time interval of less than 100 ms), and therefore, power consumption of this solution is relatively high. As shown in FIG. 8, to reduce power consumption, based on the active method, an embodiment of this application further provides a touch key assembly. In this solution, in addition to a drive unit 61 and a vibration sensing unit 62, a sensor 300 further includes a force sensing unit 63. The force sensing unit 63 is configured to sense a force or a deformation. A control circuit 400 first detects a force sensing signal $S_f$ output by the force sensing unit 63 without sending a drive signal $S_d$. In this case, the control circuit 400 does not output the drive signal $S_d$, and therefore this detection manner may be referred to as "passive" detection. When the control circuit 400 detects that pressure sensed by the force sensing unit 63 satisfies an active action condition, for example, exceeds a specified active action threshold, the control circuit 400 starts to output the drive signal $S_d$ to the drive unit 61. The drive unit 61 receives the drive signal $S_d$ and drives a shell 10 to vibrate together. In this case, the vibration sensing unit 62 outputs a vibration sensing signal $S_z$ in response to the vibration. The control circuit 400 detects the vibration sensing signal $S_z$ output by the vibration sensing unit 62 and determines whether to trigger an event. This detection manner is referred to as "active" detection. During the "active" detection, the control circuit 400 may determine, based on a degree of attenuation or increase of the detected vibration sensing signal $S_z$, whether to trigger an event. In this solution, the control circuit 400 does not need to frequently send the drive signal $S_d$ to the sensor 300 because a manner of combination of "active" detection and "passive" detection is used, so that power consumption of a key can be reduced.

Optionally, the foregoing manner of determining whether the active action condition is satisfied may include determining whether the force sensed by the force sensing unit 63 exceeds the specified active action threshold, or may further include determining, based on a forming pattern corresponding to the force sensed by the force sensing unit 63, whether the active action condition, for example, double-tap or touch and hold, is satisfied.

Optionally, the force sensing unit 63 may be a device of any one of the following types: a piezoelectric device, a piezoresistive device, a piezocapacitive device, and a piezoinductive device.

It should be noted that, during actual application, the drive unit 61, the vibration sensing unit 62, and the force sensing unit 63 may include separate discrete components, or the sensor 300 may include fewer components by reusing the components. For example, in some examples, the vibration sensing unit 62 and the force sensing unit 63 may reuse a same device. Alternatively, the drive unit 61, the vibration sensing unit 62, and the force sensing unit 63 may reuse a same device.

Optionally, the foregoing drive signal $S_d$ may be an alternating current waveform, and the alternating current waveform includes but is not limited to at least one of the following types: a square wave, a triangular wave, a sawtooth wave, a sine wave, and the like. In an example, the alternating current waveform may be, for example, a square wave including several pulses. A frequency of the drive signal $S_d$ may be the same as or close to a resonance frequency of a composite resonator, to help drive the sensor 300 to drive the shell 10 to vibrate.

Optionally, the control circuit 400 may be a control chip of the sensor. For example, the control circuit 400 may be used as the control chip of the sensor, and be integrated in a same package as the sensor 300. Alternatively, the control circuit 400 and the sensor 300 may be separately packaged. The control circuit 400 may be integrated into a central processing unit, an application processor, or a coprocessor of an electronic device. The coprocessor (coprocessor) is a chip, configured to alleviate a specific processing task of a system microprocessor, and is a processor developed and applied to assist the central processing unit in completing processing work that the central processing unit cannot execute or processing work with low execution efficiency and a poor execution effect. Certainly, the control circuit 400 may alternatively be disposed as a hardware circuit independent of a primary chip or a processor. Optionally, the control circuit 400 may include several discrete elements, or may be implemented by a same integrated chip. This is not limited in this embodiment of this application.

Optionally, if a circuit unit that performs a function of the touch key assembly and the control circuit 400 are disposed in different modules, the module may be a chip. For example, the control circuit 400 is a control chip packaged together with the sensor. The circuit unit that performs the function of the touch key assembly is a processing chip of the electronic device, for example, a central processing unit, a coprocessor, or an application processor. Then, the foregoing triggering an event may include sending, by the control circuit 400, a trigger signal, and receiving, by the circuit unit that performs the function of the touch key assembly, the trigger signal, and performing a corresponding function, for example, power-on or volume adjustment based on the trigger signal.

Optionally, if the control circuit 400 includes a function of the central processing unit, the coprocessor, or the application processor, the foregoing triggering an event includes performing, by the control circuit 400, the function of the touch key assembly.

Optionally, if the control circuit 400 includes the circuit unit that performs the function of the touch key assembly, the triggering an event may include performing, by the control circuit 400, the function of the touch key assembly.

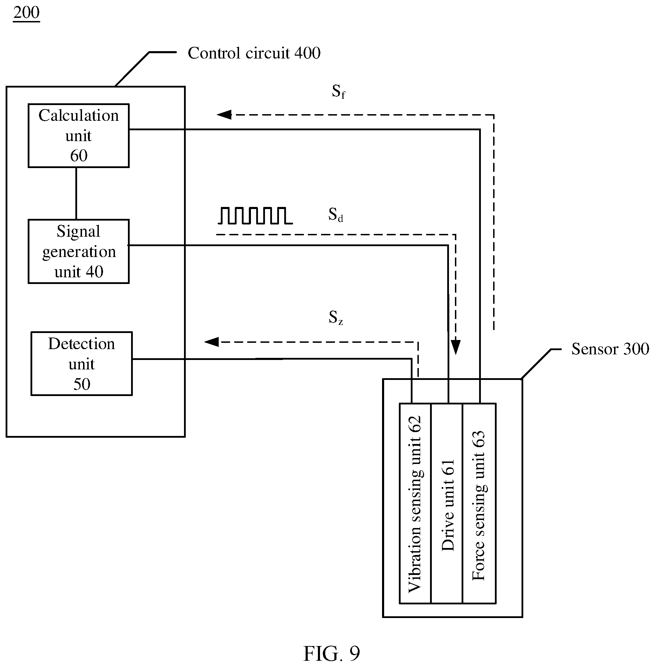

FIG. 9 is a schematic structural diagram of a touch key assembly according to another embodiment of this application. As shown in FIG. 9, the touch key assembly includes a sensor 300 and a control circuit 400. The control circuit 400 is connected to the sensor 300, and is configured to drive and detect the sensor 300. The touch key assembly may also be referred to as a touch sensing module or a touch key assembly. Some or all of functions of the control circuit 400 may be integrated on a same chip, or may be implemented by discrete devices. For example, all or some of the functions of the control circuit 400 may be implemented by a microcontroller unit (MCU). Optionally, the control circuit 400 may be disposed on a printed circuit board (PCB).

The control circuit 400 includes a signal generation unit 40, a detection unit 50, and a calculation unit 60. The sensor 300 includes a drive unit 61, a vibration sensing unit 62, and a force sensing unit 63. The signal generation unit 40 is connected to the drive unit 61, and the signal generation unit 40 is configured to input a drive signal $S_d$ to the drive unit 61. The detection unit 50 is connected to the vibration sensing unit 62, and the detection unit 50 is configured to detect a vibration sensing signal $S_z$ output by the vibration sensing unit 62. If a user touches a region in which the sensor 300 is located, amplitude of the vibration sensing signal $S_z$ attenuates or increases. The detection unit 50 may determine, by detecting a degree of attenuation or increase of the vibration sensing signal $S_z$, whether to trigger an event.

The calculation unit 60 is connected to the force sensing unit 63, and the calculation unit 60 is configured to: detect a force sensing signal $S_f$ generated by the force sensing unit 63, and perform calculation. The calculation unit 60 is configured to control the signal generation unit 40 to be started when a preset condition is satisfied, so that the signal generation unit 40 does not need to be always in a working state, to reduce power consumption.

The force sensing signal $S_f$ detected by the calculation unit 60 is a signal generated by the force sensing unit 63 when the drive unit 61 does not receive the drive signal $S_d$. Therefore, a manner in which the calculation unit 60 detects the signal may be referred to as "passive" detection. The vibration sensing signal $S_z$ detected by the detection unit 50 is a signal of the vibration sensing unit 62 in response to vibration of a composite resonator. In this case, a manner in which the detection unit 50 detects the signal may be referred to as "active" detection. Because the "active" detection manner requires the signal generation unit 40 to output the drive signal $S_d$, the power consumption is relatively high. In this embodiment of this application, the "active" detection is combined with the "passive" detection to implement a control solution for a virtual key. The "active" detection is started by using the "passive" detection. Therefore, the "active" detection manner does not need to always work, to implement good false trigger resistance and reduce power consumption.

Specifically, when the force sensing unit 63 senses a touch force, the force sensing unit 63 generates a deformation and outputs the force sensing signal $S_f$ corresponding to the deformation. The calculation unit 60 is configured to detect the force sensing signal $S_f$ generated by the force sensing unit 63. When the force sensed by the force sensing unit 63 satisfies an active action condition, for example, exceeds a specified active action threshold, the calculation unit 60 sends an indication signal to the signal generation unit 40, to indicate the signal generation unit 40 to start to output the drive signal $S_d$. After the signal generation unit 40 outputs the drive signal $S_d$ to the drive unit 61, the drive unit 61 drives a shell to vibrate, so that the vibration sensing unit 62 outputs the vibration sensing signal $S_z$. The detection unit 50 starts to detect the vibration sensing signal $S_z$ in the "active" detection state, and determines, based on a degree of the attenuation or increase of the amplitude of the vibration sensing signal $S_z$, whether to trigger an event. In this manner, the signal generation unit 40 only needs to start to output the drive signal $S_d$ when the calculation unit 60 sends the indication signal, and does not need to be always in the working state. Therefore, the drive signal $S_d$ does not need to be frequently sent, to reduce power consumption.

Optionally, detecting, by the calculation unit 60, whether the force applied to the sensor 300 satisfies the active action condition includes a plurality of manners. For example, the calculation unit 60 may calculate a force or an accelerating force based on the detected force sensing signal $S_f$, and determine whether the force or the accelerating force reaches the active action threshold. Alternatively, the calculation unit 60 may not calculate the force or the accelerating force first, but start to calculate the force or the accelerating force after the detected force sensing signal $S_f$ satisfies a condition for starting calculation, and determine whether the force or the accelerating force reaches the active action threshold. Alternatively, the calculation unit 60 may be a comparison circuit. When a level of the force sensing signal $S_f$ exceeds the active action threshold, the calculation unit 60 outputs an indication signal, to indicate the signal generation unit 40 and the detection unit 50 to start to work. Alternatively, the calculation unit 60 may be an interrupt circuit. When amplitude of the level of the force sensing signal $S_f$ or a rising edge and a falling edge of the force sensing signal $S_f$ satisfy a trigger condition, the calculation unit 60 starts an interrupt program, and after the interrupt program is started, the signal generation unit 40 and the detection unit 50 start to work. Alternatively, the calculation unit 60 may be implemented by using another specific circuit, provided that the calculation unit 60 can enable a function of the detection unit 50 when a preset condition is satisfied.

In this embodiment of this application, the calculation unit starts calculating the force and/or the accelerating force only when the force sensing signal $S_f$ reaches a preset condition. Therefore, the calculation unit does not need to always perform a function of calculating the force and/or the accelerating force, to reduce power consumption.

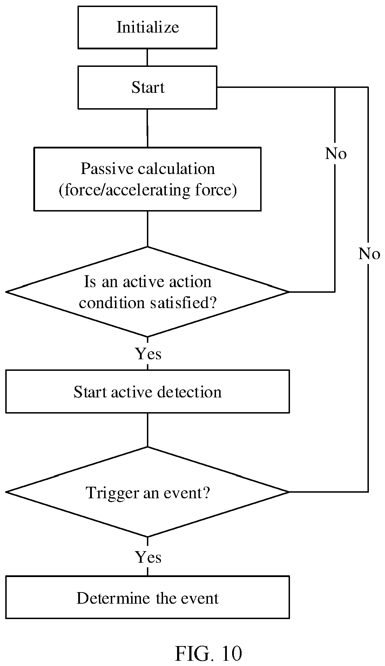

FIG. 10 is a flow block diagram of determining, by a touch key assembly, whether to trigger an event according to an embodiment of this application. As shown in FIG. 10, a process of triggering a key includes: after initialization, calculating, in a "passive" detection manner, a force or an accelerating force applied to a sensor, and determining whether the force or the accelerating force satisfies an active action condition; if the force or the accelerating force satisfies the active action condition, starting an "active" detection manner; if the force or the accelerating force does not satisfy the active action condition, returning to a starting phase; in a case of the "active" detection, outputting, by a control circuit, a drive signal $S_d$ to the sensor, to drive the sensor to vibrate, detecting a vibration sensing signal $S_z$ output by the sensor, and determining, based on the vibration sensing signal $S_z$, whether to trigger an event; if the control circuit determines to trigger an event, determining the event; and if the control circuit determines not to trigger an event, returning to the starting phase.

The determining whether the force or the accelerating force satisfies an active action condition includes determining whether the force or the accelerating force reaches an active action threshold. A value of the active action threshold may be determined based on an actual application. This is not limited in this embodiment of this application. In some examples, the active action threshold may be a threshold for starting "active" detection. For example, the active action threshold may be set to a calculation unit obtained value corresponding to a force of 200 grams. The calculation unit obtained value may refer to a dimension used by the calculation unit to determine the force or the accelerating force based on a force sensing signal $S_f$.

Based on determining whether to trigger an event shown in FIG. 10, there may be many variants. For example, the "passive" calculation of the force or the accelerating force is not required at the beginning, and the "passive" calculation of the force and the accelerating force is started only after the force sensing signal $S_f$ reaches a particular threshold. Alternatively, an interrupt circuit may be used to start the "passive" calculation of the force and the accelerating force. Alternatively, a manner of simultaneous "active" and "passive" detection may be used. A manner of determining whether to trigger an event continues to be described in a subsequent specific embodiment of this application with reference to the accompanying drawings.

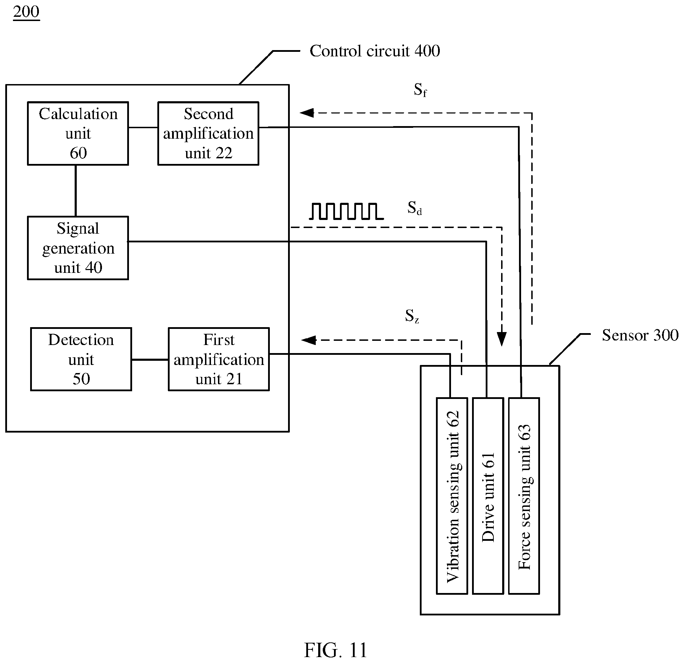

FIG. 11 is a schematic structural diagram of a touch key assembly according to another embodiment of this application. As shown in FIG. 11, the touch key assembly includes a sensor 300 and a control circuit 400. The control circuit 400 further includes a first amplification unit 21. The first amplification unit 21 is disposed between a vibration sensing unit 62 and a detection unit 50. The first amplification unit 21 is configured to: amplify a vibration sensing signal $S_z$ output by the vibration sensing unit 62 and output the amplified vibration sensing signal $S_z$. The detection unit 50 is configured to detect the amplified vibration sensing signal $S_z$.

In this embodiment of this application, the detection unit 50 detects the amplified vibration sensing signal $S_z$ output by the sensor 300, to help determine, more precisely and sensitively, whether to trigger an event, thereby improving sensitivity and false trigger resistance of a virtual key.

Optionally, still refer to FIG. 11. The control circuit 400 may further include a second amplification unit 22, and the second amplification unit 22 is disposed between the force sensing unit 63 and a calculation unit 60. The second amplification unit 22 is configured to: amplify a force sensing signal $S_f$ output by the force sensing unit 63, and output the amplified force sensing signal $S_f$.

In some examples, the first amplification unit 21 and/or the second amplification unit may include a circuit that implements an amplification function. For example, the first amplification unit 21 and/or the second amplification unit 22 may include but are not limited to at least one of the following components: a charge amplifier, a current amplifier, an operational amplifier, a rectifier amplifier, an envelope amplifier, a comparison amplifier, and the like.

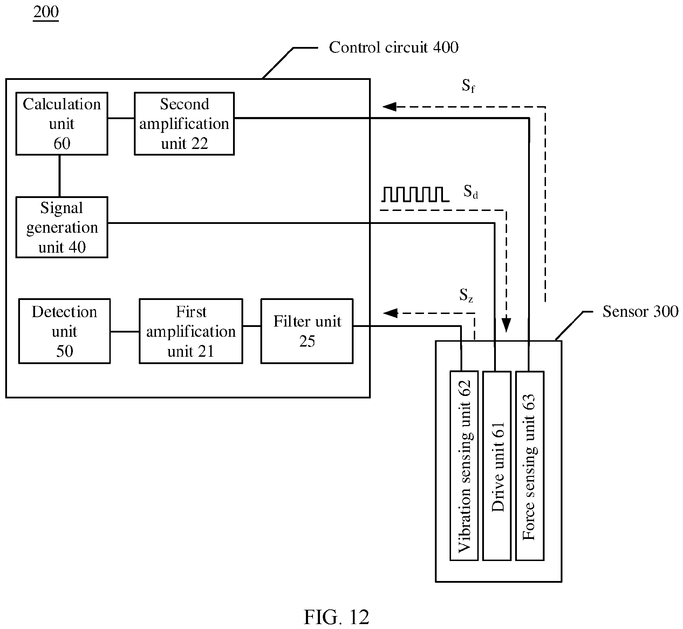

FIG. 12 is a schematic structural diagram of a touch key assembly according to another embodiment of this application. As shown in FIG. 12, the touch key assembly includes a sensor 300 and a control circuit 400. The control circuit 400 further includes a filter unit 25. The filter unit 25 is configured to filter a vibration sensing signal $S_z$ output by a vibration sensing unit 62. The filter unit 25 may perform high-pass filtering on the vibration sensing signal $S_z$. The filter unit 25 may be disposed between the vibration sensing unit 62 and a detection unit 50. The filter unit 25 may be separately disposed, or may be integrated in a first amplification unit 21, or may be integrated in the detection unit 50, or may be implemented through digital filtering. This is not limited in this embodiment of this application.

In some examples, the filter unit 25 may perform high-pass filtering, to prevent a low frequency signal from making a signal output by the first amplification unit 21 drift. In some examples, the filter unit 25 may include a first-order high-pass filter circuit, or may include a higher-order high-pass filter circuit. This is not limited in this embodiment of this application.

In this embodiment of this application, high-pass filtering may be implemented on the vibration sensing signal $S_z$ by using the filter unit, to stabilize a baseline of the vibration sensing signal $S_z$, thereby improving efficiency of detecting a virtual key.

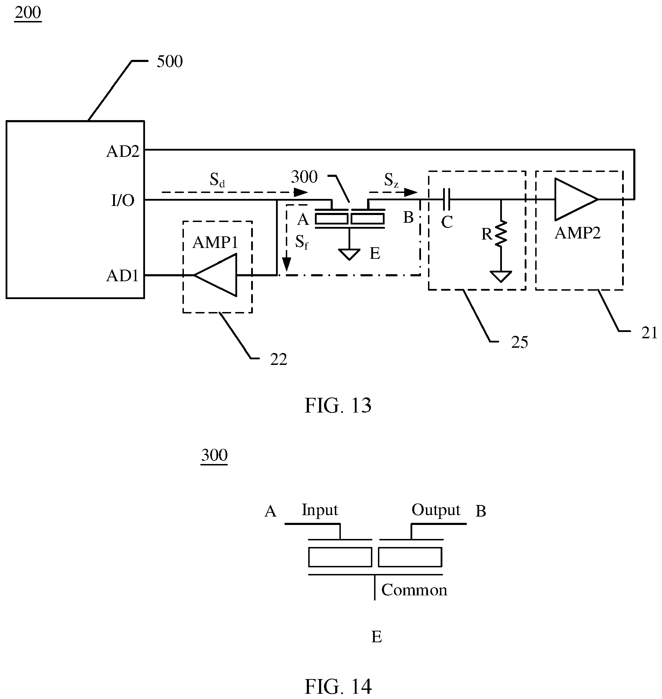

FIG. 13 is a circuit schematic diagram of a touch key assembly according to another embodiment of this application. The signal generation unit 40, the detection unit 50, and the calculation unit 60 in FIG. 9, FIG. 11, or FIG. 12 may be integrated into a same control chip 500. The control chip 500 may be implemented by an MCU. FIG. 13 does not show a connection relationship between function units in the control chip 500. For the connection relationship between the function units, refer to the descriptions in the foregoing specific embodiments. An I/O port represents an output terminal of the signal generation unit 40, and is configured to output a drive signal $S_d$. An AD 1 port represents an input terminal of the calculation unit 60, and is configured to: detect a force sensing signal $S_f$ output by a sensor 300, and determine whether to start the signal generation unit 40, to make the I/O port output the drive signal $S_d$. An AD2 port represents an input terminal of the detection unit 50, and is configured to: after the signal generation unit 40 is started, detect a vibration sensing signal $S_z$ output by the sensor 300, and determine whether to trigger an event.

A first port A of the sensor 300 is configured to receive the drive signal $S_d$. The first port A and a second port B of the sensor 300 may both be configured to output the force sensing signal $S_f$ generated by the force sensing unit. The second port B of the sensor 300 is configured to output the vibration sensing signal $S_z$ generated by a vibration sensing unit. As shown in FIG. 13, the input terminal AD 1 of the calculation unit not only may be connected to the first port A of the sensor 300, but also may be connected to the second port B of the sensor 300 (as shown by the dotted lines).

Optionally, a second amplification unit 22 is disposed between the AD 1 port and the first port A of the sensor 300, and is configured to amplify the force sensing signal $S_f$. The second amplification unit 22 includes an amplifier AMP1. A first amplification unit 21 is disposed between the AD2 port and the second port B of the sensor 300, and is configured to amplify the vibration sensing signal $S_z$. The first amplification unit 21 includes an amplifier AMP2. A filter unit 25 may also be disposed between the AD2 port and the second port B of the sensor 300, and is configured to perform high-pass filtering on the vibration sensing signal $S_z$. The filter unit 25 includes a capacitor C and a resistor R. Alternatively, the filter unit 25 may be integrated in the amplifier AMP2, or may be integrated in the control chip 500. This is not limited in this embodiment of this application. FIG. 13 is merely an example of specific implementation of the foregoing function units. A person skilled in the art may understand that the foregoing function units further have a plurality of other specific implementations or variations, which shall fall within the protection scope of this application.

In a specific example, when the control chip 500 works, a starting state of the I/O port is a high impedance state or a floating state. The AD1 port samples, at a particular sampling rate, the force sensing signal $S_f$ output by the sensor 300, to determine whether pressure applied to the sensor 300 satisfies a condition for starting calculation, for example, exceeds a specified threshold for starting calculation. To reduce power, the foregoing sampling may be performed at a relatively low sampling rate, for example, less than 1 kHz/s. If the touch force sensed by the sensor 300 reaches the condition for starting calculation, the calculation unit calculates, based on the force sensing signal $S_f$ detected by the AD 1 port, the force or the accelerating force applied to the sensor 300, and determines whether the calculated force or accelerating force satisfies an active action condition, for example, exceeds an active action threshold. If the calculated force or accelerating force satisfies the active action condition, the signal generation unit starts to send the drive signal $S_d$ by using the I/O port. A frequency of the drive signal $S_d$ may be equal to or close to a resonance frequency of a composite resonator. The detection unit detects, by using the AD2 port, the vibration sensing signal $S_z$ amplified by the amplifier AMP2, and determines, based on the vibration sensing signal $S_z$, whether to trigger an event.

Optionally, the foregoing manner of determining whether the condition for starting calculation is satisfied may include determining whether the force sensed by the force sensing unit 63 exceeds the specified threshold for starting calculation, or may further include determining, based on a forming pattern corresponding to the force sensed by the force sensing unit 63, whether the condition for starting calculation, for example, double-tap or touch and hold, is satisfied.

Values of the threshold for starting calculation and the active action threshold may be determined based on actual application. This is not limited in this embodiment of this application. In some examples, the threshold for starting calculation may be a threshold for starting calculation of the force or the accelerating force. The active action threshold may be a threshold for starting "active" detection. For example, the threshold for starting calculation may be set to a calculation unit obtained value corresponding to a force of 100 grams, and the active action threshold may be set to a calculation unit obtained value corresponding to a force of 200 grams. If the threshold for starting calculation is exceeded, the calculation unit starts to calculate the force or the accelerating force, and determines whether the force or the accelerating force sensed by the sensor 300 exceeds the active action threshold. When the force or the accelerating force exceeds the active action threshold, the signal generation unit starts to work.

A type of the sensor in FIG. 13 is "piezoelectric input/piezoelectric output". The piezoelectric input means that the drive unit of the sensor is a piezoelectric device, and the piezoelectric output means that the vibration sensing unit and the force sensing unit of the sensor are piezoelectric devices. FIG. 14 is a schematic structural diagram of a "piezoelectric input/piezoelectric output"-type sensor 300 according to an embodiment of this application. As shown in FIG. 14, a drive unit of the sensor 300 is a piezoelectric device, and an input terminal of the sensor 300 is a first port A. A vibration sensing unit is also a piezoelectric device, and an output terminal of the sensor 300 is a second port B. A force sensing unit may reuse the piezoelectric device used as the drive unit, or reuse the piezoelectric device used as the vibration sensing unit, and an output terminal of the sensor 300 may be the first port A or the second port B. Specifically, the first port A is configured to receive a drive signal $S_d$, and the drive signal $S_d$ drives the sensor 300 to drive a shell to vibrate. The second port B is configured to output a vibration sensing signal $S_z$ in response to vibration. The first port A or the second port B may also be configured to output a force sensing signal $S_f$ generated by the force sensing unit. A third port E is a common end, and is usually used for grounding. When active detection is performed, the vibration sensing signal $S_z$ output by the second port B of the sensor 300 may be detected. When passive detection is performed, because the first port A of the sensor 300 does not receive the drive signal $S_d$, the input terminal A and the output terminal B of the sensor 300 may both output the force sensing signal $S_f$. In this case, both the force sensing signal $S_f$ output by the input terminal A of the sensor 300 and the force sensing signal $S_f$ output by the output terminal B can be detected, or the force sensing signals $S_f$ output by the input terminal A and the output terminal B are detected at the same time. In FIG. 13, the input terminal AD 1 of the calculation unit may be connected to the first port A of the sensor 300, may be connected to the second port B of the sensor 300, or may be connected to both the input terminal A and the output terminal B of the sensor 300. An amplifier may be further disposed between the AD 1 port and the sensor 300, to amplify a signal output by the sensor 300.

Optionally, the sensor in this embodiment of this application is not limited to the type of "piezoelectric input/piezoelectric output", and another type of sensor may be used, for example, a type of "piezoelectric input/piezoresistive output", that is, the drive unit is a piezoelectric device, and the sensing unit is a piezoresistive device. Alternatively, the drive unit may be a device of any one of the following types: a piezoelectric device, a magnetomechanical device, an electric device, and a thermoelectric device. The sensing unit may be a device of any one of the following types: a piezoelectric device, a piezoresistive device, a piezocapacitive device, and a piezoinductive device. The foregoing type of a combination of the drive unit and the vibration sensing unit may implement "active-passive" composite detection. In this detection manner, a unit in the sensor in active detection is usually reused to detect a force, to implement composition of active and passive detection, thereby implementing false trigger resistance and good force experience. In some other examples, for force detection to be performed in an active manner, that is, force detection to be performed by actively sending the drive signal $S_{d2}$, for example, an inductive measurement method, optionally, an "active-active" composite mode may also be used. One active manner is used for force detection and the other active manner is used for human body detection. The method is similar to the "active-passive" detection manner, and details are not described herein again. In this application, a type of the sensor continues to be described in a subsequent specific implementation in this application.

For a process of calculating a force or an accelerating force based on passive detection, the following describes the process based on FIG. 13 by using an example in which the sensor 300 is a piezoelectric device. A charge Q output by the piezoelectric device and an applied external force F are generally linearly related, and a relationship therebetween is shown in formula (1).

$$Q = A \times F \tag{1}$$

where A represents a coefficient.

A voltage V output by an AMP1 is related to the charge Q, and a relationship therebetween in time domain may be expressed as formula (2).

$$Q(t) = H(V(t)) \tag{2}$$

where t represents time, and the H function represents a time domain function of the amplifier AMP 1. The H function is related to a design of the amplifier AMP 1. Once the amplifier AMP 1 is designed, the H function of the amplifier AMP1 is determined. According to the foregoing formulas, a relationship between the force F or the accelerating force dF/dt and the H function may be obtained, and the relationships are respectively shown in formula (3) and formula (4).

$$F = H(V(t))/A \tag{3}$$

$$dF/dt = (1/A) \times dH/dt \tag{4}$$

According to formula (3) and formula (4), the force or the accelerating force may be obtained based on a sensing signal output by the amplifier AMP1. Optionally, if the control circuit 400 does not include the amplifier AMP1, a calculation manner of obtaining the force or the accelerating force may be further simplified, and details are not described herein again.

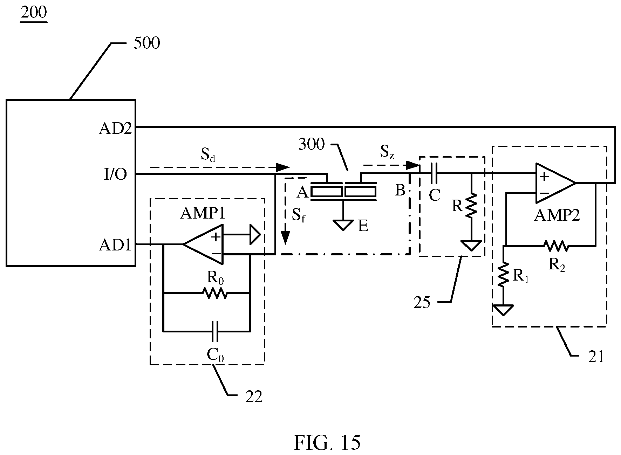

FIG. 15 is a circuit schematic diagram of a touch key assembly according to another embodiment of this application. For brevity, parts that are the same as or similar to those in FIG. 13 in the touch key assembly in FIG. 15 are not described herein again.

As shown in FIG. 15, a resistor Ro and a capacitor Co are disposed between a negative input terminal and an output terminal of the amplifier AMP 1. The resistor Ro is connected in parallel to the capacitor Co. A first terminal of the resistor Ro and a first terminal of the capacitor Co are connected to the negative input terminal of the amplifier AMP1, and a second terminal of the resistor Ro and a second terminal of the capacitor Co are connected to the output terminal of the amplifier AMP 1. For example, to improve a detection effect, a resistance value of the resistor Ro may be increased. For example, the resistance value of the resistor Ro may be greater than 1 M$\Omega$.

As shown in FIG. 15, a resistor R1 is connected in series between a negative input terminal of the amplifier AMP2 and ground, and a resistor R2 is connected in series between the negative input terminal of the AMP2 and an output terminal of the amplifier AMP2.

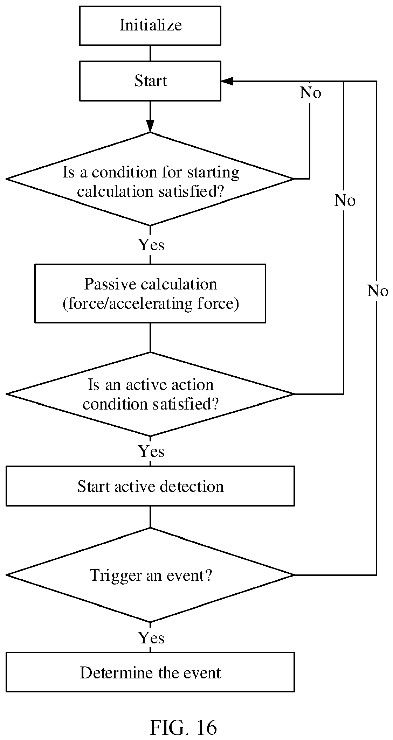

FIG. 16 is a flow block diagram of determining, by a touch key assembly, whether to trigger an event according to another embodiment of this application. As shown in FIG. 16, a process of triggering a key includes: after initialization, first starting a "passive" detection manner to sample a force sensing signal $S_f$ output by a sensor, where in this period, a force or an accelerating force sensed by the sensor does not need to be calculated; when a sampled signal satisfies a condition for starting calculation, then calculating, in a "passive" detection manner, the force or the accelerating force sensed by the sensor, and determining whether the force or the accelerating force satisfies an active action condition; if the sampled signal does not satisfy the condition for starting calculation, returning to a starting phase; if the calculated force or accelerating force satisfies the active action condition, starting an "active" detection manner; in a case of the "active" detection, outputting, by a control circuit, a drive signal $S_d$ to the sensor, detecting a vibration sensing signal $S_z$ output by the sensor, and determining, based on the vibration sensing signal $S_z$, whether to trigger an event; if the calculated force or accelerating force does not satisfy the active action condition, returning to the starting phase; if the control circuit determines to trigger an event, determining the event; and if the control circuit determines not to trigger an event, returning to the starting phase.

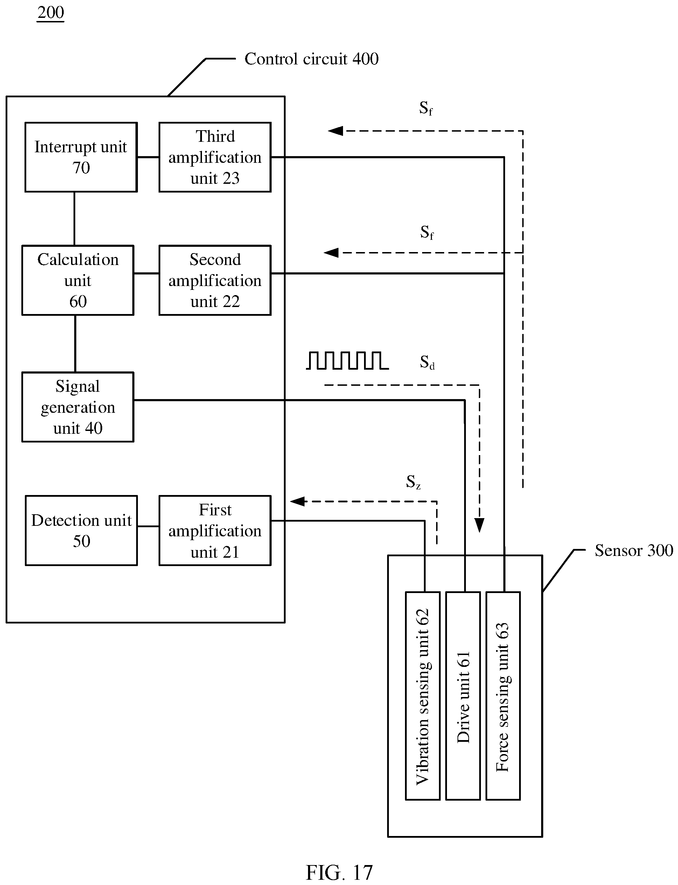

FIG. 17 is a schematic structural diagram of a touch key assembly according to another embodiment of this application. As shown in FIG. 17, the touch key assembly includes a sensor 300 and a control circuit 400. The control circuit 400 includes a signal generation unit 40, a detection unit 50, a calculation unit 60, and an interrupt unit 70. The sensor 300 includes a drive unit 61, a vibration sensing unit 62, and a force sensing unit 63. The interrupt unit 70 is configured to: detect a force sensing signal $S_f$ output by the force sensing unit 63, and control starting of the calculation unit 60. Specifically, the interrupt unit 70 may implement a function of determining whether a touch force sensed by the sensor 300 satisfies a condition for starting calculation (for example, exceeds a threshold for starting calculation). When the touch force satisfies the condition for starting calculation, the interrupt unit 70 may control the calculation unit 60 to be started. Then the calculation unit 60 starts to calculate a force or an accelerating force applied to the sensor 300, and determines whether the obtained force and/or accelerating force satisfies an active action condition, for example, exceeds an active action threshold. When the obtained force and/or accelerating force satisfies the active action condition, the calculation unit 60 sends an indication signal to the signal generation unit 40, to indicate the signal generation unit 40 to start to work.

It may be understood that, in FIG. 17, the interrupt unit 70 determines whether the pressure satisfies the condition for starting calculation, and the calculation unit 60 determines whether the force or the accelerating force satisfies the active action condition.

In this embodiment of this application, the interrupt unit 70 controls starting of the calculation unit 60, and the calculation unit 60 controls starting of the signal generation unit 40. Therefore, the calculation unit 60 and the signal generation unit 40 work only when a preset condition is satisfied, thereby reducing power consumption of the circuit.

Optionally, the interrupt unit 70 may be implemented by an interrupt circuit, and the interrupt circuit is started only when an input voltage or current satisfies a preset condition. A type of the interrupt circuit may be level interrupt, rising edge interrupt, or falling edge interrupt. If the force sensing signal $S_f$ output by the sensor 300 satisfies a pre-designed level requirement, rising edge requirement or falling edge requirement, an interrupt program is entered. The calculation unit 60 is connected to the interrupt unit 70, and the calculation unit 60 is started after the interrupt program is entered. In other words, the interrupt unit 70 is equivalent to a switch for controlling the calculation unit 60. The calculation unit 60 starts to work only when the interrupt unit 70 starts the interrupt program. The interrupt unit 70 may be designed, so that when the pressure sensed by the sensor 300 satisfies the condition for starting calculation, the interrupt unit 70 is started. The interrupt unit 70 is connected to the calculation unit 60, and when the interrupt unit 70 is started, the calculation unit 60 starts to work. Optionally, that the interrupt unit 70 determines whether the pressure sensed by the sensor 300 satisfies the condition for starting calculation may also be understood as follows: The interrupt unit 70 determines whether the force sensing signal $S_f$ output by the sensor 300 satisfies an interrupt condition.

Therefore, when the touch force sensed by the sensor 300 satisfies the condition for starting calculation, the interrupt unit 70 is not started, and the control circuit 400 hardly generates power consumption. The interrupt unit 70 is started only when the touch force satisfies the condition for starting calculation, and correspondingly, the calculation unit 60 is started to work. Therefore, in the solution of this embodiment of this application, circuit power consumption can be reduced when good false trigger resistance is implemented.

Optionally, a third amplification unit 23 may also be disposed between the interrupt unit 70 and the force sensing unit 63. The interrupt unit 70 receives and detects the force sensing signal $S_f$ amplified by the third amplification unit 23. Through designing, when the touch force applied to the sensor 300 satisfies the condition for starting calculation, the amplified force sensing signal $S_f$ causes the interrupt unit 70 to start the interrupt program.

In some examples, the third amplification unit 23 may include a circuit that implements an amplification function. For example, the third amplification unit 23 may include but is not limited to at least one of the following components: a charge amplifier, a current amplifier, an operational amplifier, a rectifier amplifier, an envelope amplifier, a comparison amplifier, and the like.

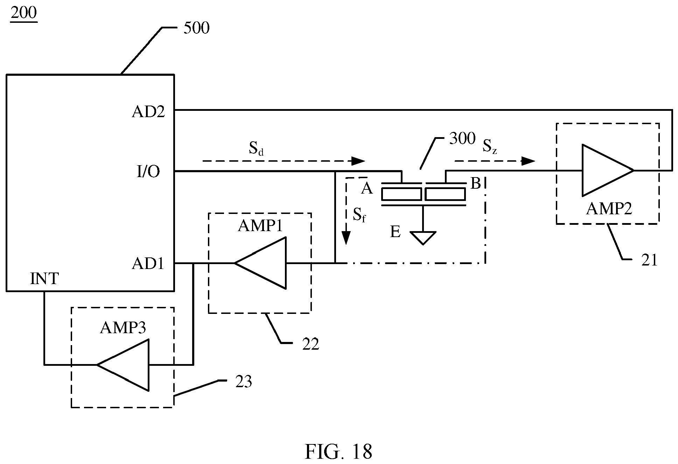

FIG. 18 is a circuit schematic diagram of a touch key assembly according to another embodiment of this application. The signal generation unit 40, the detection unit 50, the calculation unit 60, and the interrupt unit 70 in FIG. 17 may be integrated into a same control chip 500. The control chip 500 may be implemented by an MCU. FIG. 18 does not show a connection relationship between function units in the control chip 500. For the connection relationship between the function units, refer to the descriptions in the foregoing embodiments. An I/O port represents an output terminal of the signal generation unit 40, and is configured to output a drive signal $S_d$. An INT port represents an input terminal of the interrupt unit 70, and is configured to: detect a force sensing signal $S_f$ output by a sensor 300, and determine whether to start the calculation unit 60. An AD 1 port represents an input terminal of the calculation unit 60, and is configured to: detect the force sensing signal $S_f$ output by the sensor 300, and determine whether to start the signal generation unit 40, to make the I/O port output the drive signal $S_d$. An AD2 port represents an input terminal of the detection unit 50, and is configured to: after the signal generation unit 40 is started, detect a vibration sensing signal $S_z$ output by the sensor 300, and determine whether to trigger an event.

A first port A of the sensor 300 is configured to receive the drive signal $S_d$. A second port B of the sensor 300 is configured to output the vibration sensing signal $S_z$ generated by a vibration sensing unit. The first port A and the second port B of the sensor 300 may both be configured to output the force sensing signal $S_f$ generated by a force sensing unit. As shown in FIG. 18, the input terminal INT of the interrupt unit and the input terminal AD1 of the calculation unit not only may be connected to the first port A of the sensor 300, but also may be connected to the second port B of the sensor 300 (as shown by the dotted lines), or may be connected to both the input terminal A and the output terminal B of the sensor 300.

The interrupt unit sends an interrupt signal only when the interrupt unit detects that the signal output by the sensor 300 satisfies an interrupt condition, to enable the calculation unit to start to work. Alternatively, when a force sensed by the sensor 300 satisfies a condition for starting calculation, the calculation unit is started. Then, the calculation unit starts to calculate the force and/or accelerating force applied to the sensor 300, and determines whether the calculated force and/or accelerating force satisfies an active action condition. If the calculated force and/or accelerating force satisfies the active action condition, the calculation unit sends an indication signal to the signal generation unit, to indicate the signal generation unit to start to work.

Optionally, a second amplification unit 22 is disposed between the input terminal AD 1 of the calculation unit and the first port A of the sensor 300, and is configured to amplify the force sensing signal $S_f$. The second amplification unit 22 includes an amplifier AMP 1. A first amplification unit 21 is disposed between the input terminal AD2 of the detection unit and the second port B of the sensor 300, and is configured to amplify the vibration sensing signal $S_z$. The second amplification unit 21 includes an amplifier AMP2. Optionally, a third amplification unit 23 may also be disposed between the input terminal INT of the interrupt unit and the first port A of the sensor 300, and is configured to amplify the force sensing signal $S_f$. The third amplification unit 23 includes an amplifier AMP3. Optionally, a filter unit (not shown in the figure) may also be disposed between the input terminal AD2 of the detection unit and the second port B of the sensor 300, and the filter unit may be configured to perform high-pass filtering on the vibration sensing signal $S_z$. Alternatively, the filter unit may be integrated in the amplifier AMP2, or may be integrated in the control chip 500. This is not limited in this embodiment of this application. FIG. 18 is merely an example of specific implementation of the foregoing function units. A person skilled in the art may understand that the foregoing function units further have a plurality of other specific implementations or variations, which shall fall within the protection scope of this application.

When the control chip 500 works, a starting state of the I/O port is a high impedance state or a floating state. The interrupt unit detects, by using the INT port, the force sensing signal $S_f$ output by the sensor 300. When the pressure sensed by the sensor 300 does not satisfy the condition for starting calculation, the force sensing signal $S_f$ output by the sensor 300 is insufficient to enable the interrupt unit to start an interrupt program, and in this case, none of the calculation unit, the signal generation unit, and the detection unit works. When the force sensed by the sensor 300 satisfies the condition for starting calculation, the force sensing signal $S_f$ output by the sensor 300 to the INT port enables the interrupt unit to be started, and the calculation unit starts to work. In this case, the calculation unit starts to calculate, based on the force sensing signal $S_f$ detected by the AD 1 port, the force or the accelerating force applied to the sensor 300, and determines whether the force or the accelerating force reaches an active action threshold. If the force or the accelerating force reaches the active action threshold, the signal generation unit starts to send the drive signal $S_d$ by using the I/O port. A frequency of the drive signal $S_d$ may be equal to or close to a resonance frequency of a composite resonator. The detection unit detects, by using the AD2 port, the vibration sensing signal $S_z$ that is amplified by the amplifier AMP2 and that is output by the sensor 300, and determines, based on the vibration sensing signal $S_z$, whether to trigger an event. The I/O port is generally in a high impedance state or a floating state at an interval during which the drive signal $S_d$ is not sent.

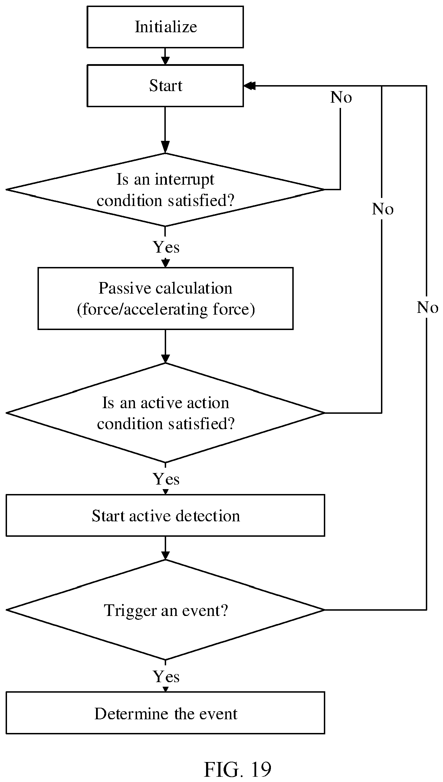

FIG. 19 is a flowchart of determining, by a touch key assembly, whether to trigger an event according to another embodiment of this application. As shown in FIG. 19, a process of triggering a key includes: after initialization, first detecting whether a force sensing signal $S_f$ output by a sensor satisfies an interrupt condition, where the interrupt condition includes, for example, a case in which a level of the force sensing signal $S_f$ output by the sensor reaches a preset level; if the force sensing signal $S_f$ output by the sensor satisfies the interrupt condition, entering an interrupt state, and starting to detect, in a "passive" detection manner, a force or an accelerating force sensed by the sensor, and determining whether the force or the accelerating force satisfies an active action condition; if the calculated force or accelerating force satisfies the active action condition, starting an "active" detection manner; in a case of the "active" detection, outputting, by a control circuit, a drive signal $S_d$ to the sensor, detecting a vibration sensing signal $S_z$ output by the sensor, and determining, based on the vibration sensing signal $S_z$, whether to trigger an event; if the calculated force or accelerating force does not satisfy the active action condition, returning to the starting phase; if the control circuit determines to trigger an event, determining the event; and if the control circuit determines not to trigger an event, returning to the starting phase.

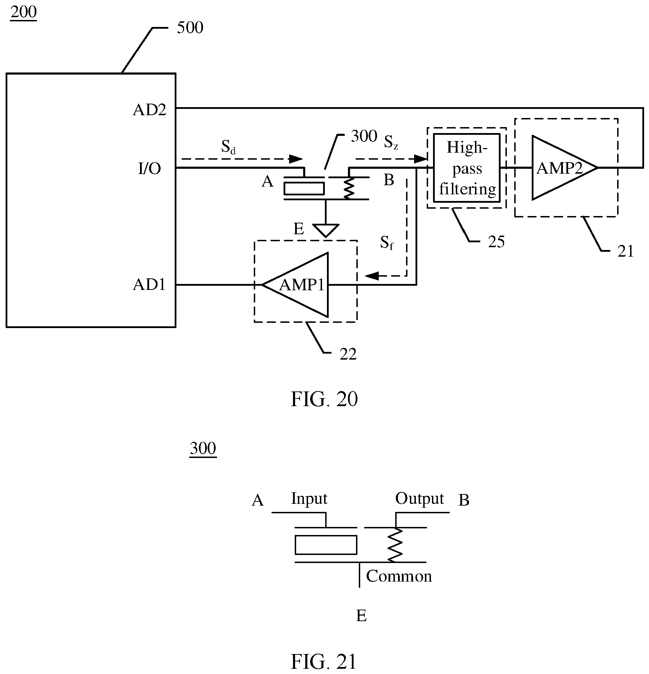

FIG. 20 is a circuit schematic diagram of a touch key assembly according to another embodiment of this application. The sensor 300 is of a type "piezoelectric input/piezoresistive output". To be specific, a drive unit of the sensor 300 is a piezoelectric device, and an input terminal of the sensor 300 is a first port A. A vibration sensing unit is a piezoresistive device, and an output terminal of the sensor 300 is a second port B. A force sensing unit may reuse the piezoelectric device used as the drive unit, or reuse the piezoresistive device used as the vibration sensing unit, and an output terminal of the sensor 300 may be the first port A or the second port B. For brevity, parts that are the same as or similar to those in the foregoing description in the touch key assembly in FIG. 20 are not described herein again. As shown in FIG. 20, a second amplification unit 22 is disposed between an input terminal AD 1 of a calculation unit and the second port B of the sensor 300, to amplify a force sensing signal $S_f$. The second amplification unit 22 includes an amplifier AMP1. A first amplification unit 21 is disposed between an input terminal AD2 of a detection unit and the second port B of the sensor 300, to amplify a vibration sensing signal $S_z$. The first amplification unit 21 includes an amplifier AMP2. A filter unit 25 may also be disposed between the input terminal AD2 of the detection unit and the second port B of the sensor 300, and the filter unit 25 may be configured to perform high-pass filtering on the vibration sensing signal $S_z$. Alternatively, the filter unit 25 may be integrated in the amplifier AMP2, or may be integrated in the control chip 500. This is not limited in this embodiment of this application. FIG. 20 is merely an example of specific implementation of the foregoing function units. A person skilled in the art may understand that the foregoing function units further have a plurality of other specific implementations or variations, which shall fall within the protection scope of this application.

It should be understood that, connection lines in FIG. 20 represent only one connection logic, rather than a specific circuit. For example, when the AD 1 port detects the force sensing signal $S_f$ output by the second port B of the sensor 300, the calculation unit detects, through resistance detection, a force or an accelerating force applied to the sensor 300. A person skilled in the art can understand that resistance detection includes a plurality of mature methods, such as a voltage division method and a bridge balancing method. For brevity, details are not described herein again.

When the control chip 500 works, a starting state of the I/O port is a high impedance state or a floating state. The AD1 port samples, at a particular sampling rate, the force sensing signal $S_f$ output by the sensor 300, to determine whether pressure applied to the sensor 300 satisfies a condition for starting calculation. To reduce power, the foregoing sampling may be performed at a relatively low sampling rate, for example, less than 1 kHz/s. If the pressure sensed by the sensor 300 satisfies the condition for starting calculation, for example, exceeds a specified threshold for starting calculation, the calculation unit calculates, based on the force sensing signal $S_f$ detected by the AD1 port, the force or the accelerating force applied to the sensor 300, and determines whether the calculated force or accelerating force satisfies an active action condition, for example, exceeds a specified active action threshold. If the calculated force or accelerating force satisfies the active action condition, a signal generation unit starts to send a drive signal $S_d$ by using the I/O port. A frequency of the drive signal $S_d$ may be equal to or close to a resonance frequency of a composite resonator. The detection unit detects, by using the AD2 port, the vibration sensing signal $S_z$ that is amplified by the amplifier AMP2 and that is output by the sensor 300, and determines, based on the vibration sensing signal $S_z$, whether to trigger an event.

In this embodiment of this application, the sensor of the "piezoelectric input/piezoresistive output" type is used, and the piezoresistive output is usually detected by using a voltage division method or a Wheatstone bridge method. In addition, the vibration sensing signal $S_z$ output by the sensor may be processed by using digital filtering, or high-pass processing may be performed by using software on the vibration sensing signal $S_z$ output by the sensor, thereby reducing hardware costs of the circuit, and reducing circuit power consumption. The force applied to the sensor is detected in a piezoresistive mode, so that hardware and software resources can be reduced, and some lowfrequency or static forces can be detected with relatively good effects.

FIG. 21 is a schematic structural diagram of a "piezoelectric input/piezoresistive output"-type sensor 300 according to an embodiment of this application. As shown in FIG. 21, a drive unit of the sensor 300 is a piezoelectric device, and an input terminal of the sensor 300 is a first port A. A vibration sensing unit is a piezoresistive device, and an output terminal of the sensor 300 is a second port B. A force sensing unit may reuse the piezoelectric device used as the drive unit, or reuse the piezoresistive device used as the vibration sensing unit, and an output terminal of the sensor 300 may be the first port A or the second port B. Specifically, the first port A is configured to receive a drive signal $S_d$, and the drive signal $S_d$ drives the sensor 300 to drive a shell to vibrate. The second port B is configured to output a vibration sensing signal $S_z$ in response to vibration. The first port A or the second port B may be further configured to output a force sensing signal $S_f$ generated by the force sensing unit. A third port E is a common end, and is usually used for grounding. When active detection is performed, the vibration sensing signal $S_z$ output by the second port B may be detected. When passive detection is performed, because the first port A does not receive the drive signal $S_d$, the first port A and the second port B of the sensor 300 both output the force sensing signal $S_f$. In this case, both the force sensing signal $S_f$ output by the first port A and the force sensing signal $S_f$ output by the second port B can be detected, or the force sensing signals $S_f$ output by the first port A and the second port B are detected at the same time, so that the force sensing unit can be flexibly configured. Therefore, in FIG. 20, the input terminal AD1 of the calculation unit may be connected to the first port A of the sensor 300, may be connected to the second port B of the sensor 300, or may be connected to both the first port A and the second port B of the sensor 300. An amplifier may be further disposed between the AD1 port and the sensor 300, to amplify a signal output by the sensor 300.

Next, a principle of calculating a force or an accelerating force in a "passive" detection manner is described by using an example in which the sensor is a piezoresistive device. First, a relationship between a resistance variation AR of the piezoresistive device and the applied force may be expressed by using formula (5).

$$F=X(\Delta R) \tag{5}$$

The X function represents a functional relationship between the resistance variation AR and the applied force F.
The resistance variation AR may be indirectly obtained by using an output voltage V of the sensor, and a relationship therebetween is shown in formula (6).

$$V=Y(\Delta R) \tag{6}$$

The Y function represents a functional relationship between the voltage signal V and the resistance variation AR.
A relationship between the output voltage V and the force F may be obtained according to formula (5) and formula (6), and a relationship therebetween is shown in formula (7).

$$F=G(V) \tag{7}$$

The G function represents a functional relationship between the output voltage V and the force F.

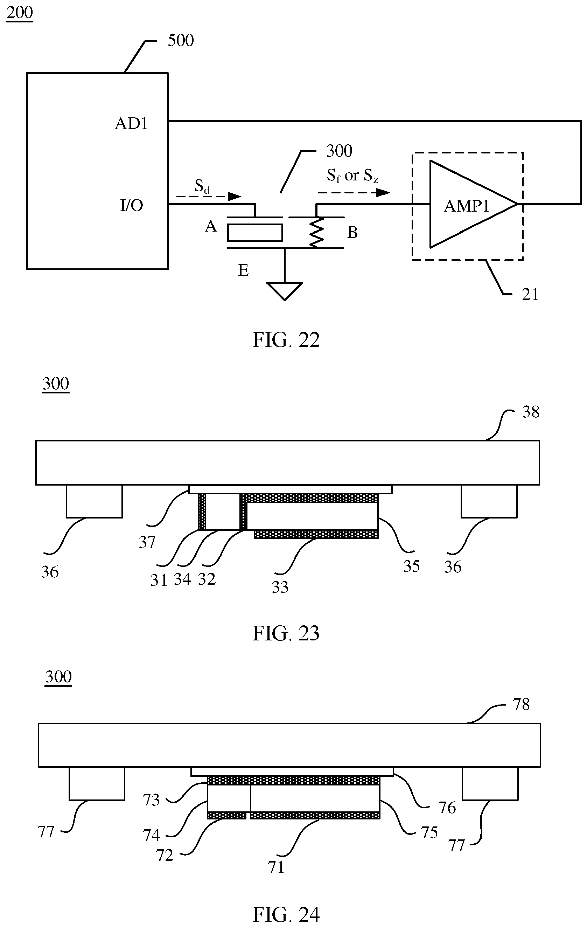

FIG. 22 is a circuit schematic diagram of a touch key assembly according to another embodiment of this application. A control chip 500 integrates a calculation unit, a detection unit, and a signal generation unit together. Compared with the previous embodiments, the control chip 500 in FIG. 22 may be further simplified. For example, the calculation unit and the detection unit may share one first port AD 1, to detect a vibration sensing signal $S_z$ or a force sensing signal $S_f$ output by the sensor 300. For example, the AD1 port may detect the force sensing signal $S_f$ when a drive signal $S_d$ is not input. When the drive signal $S_d$ is input, the AD1 port may detect the vibration sensing signal $S_z$. Optionally, in the control chip 500, filtering may also be performed on the vibration sensing signal $S_z$ by using software, and high-pass filtering is performed on the vibration sensing signal $S_z$ input into the AD1 port, to prevent a low frequency signal from interfering with obtained data.
In this embodiment of this application, a circuit used for "passive" detection may be added based on "active" detection, to implement false trigger resistant human body detection and precise force detection, thereby improving user experience. In a manner of starting the "active" detection by using the "passive" detection, an "active" detection circuit with relatively high energy consumption does not work in most cases, and is started only when a preset condition is satisfied, thereby reducing power consumption. Moreover, the passive detection responds to the force more precisely, making tactile response experience of a tactile key better.
The following continues to describe the sensor in the embodiments of this application with reference to the accompanying drawings.
FIG. 23 is a schematic structural diagram of a "piezoelectric input/piezoelectric output"-type sensor 300 according to another embodiment of this application. As shown in FIG. 23, the sensor 300 includes: an output terminal electrode 31; a common electrode 32; an input terminal electrode 33; a piezoelectric output body 34; a piezoelectric input body 35; a limit node 36; a bonding gel 37, which may be a cured gel; and a housing 38. The housing 38 and the limit node 36 may be an integral structure.
Optionally, the housing 38 may be the shell 10 shown in FIG. 3 to FIG. 6. The piezoelectric input body 35 may be used as a drive unit, the piezoelectric output body 34 may be used as a vibration sensing unit, and the piezoelectric input body 35 and the piezoelectric output body 34 may both be reused as a force sensing unit.
As shown in FIG. 23, an input of the sensor 300 may be polarized in a thickness direction, and an output may be polarized in a length direction. Therefore, performance of a relatively high output voltage may be obtained under a relatively low input voltage, to provide a voltage output signal with relatively good performance. A person skilled in the art can understand that a structure of the sensor 300 in FIG. 23 is merely used as an example, and the sensor 300 may alternatively use another structure type. This is not limited in this embodiment of this application.

FIG. 24 is a schematic structural diagram of a "piezoelectric input/piezoresistive output"-type sensor 300 according to another embodiment of this application. As shown in FIG. 24, the sensor 300 includes: an output terminal electrode 72; a common electrode 73; an input terminal electrode 71; a piezoresistive output body 74; a piezoelectric input body 75; a bonding gel 76, which may be a cured gel; a limit node 77; and a housing 78. The housing 78 and the limit node 77 may be an integral structure.

Optionally, the housing 78 may be the shell 10 shown in FIG. 3 to FIG. 6. The piezoelectric input body 75 may be used as a drive unit, the piezoresistive output body 74 may be used as a vibration sensing unit, and the piezoelectric input body 75 and the piezoelectric output body 74 may both be reused as a force sensing unit.

Optionally, there may be one or more paths of output terminal electrodes 72 of the sensor 300. For example, there may be two paths of outputs of a bridge piezoresistive sensor.

A person of ordinary skill in the art may be aware that, in combination with the examples described in the embodiments disclosed in this specification, units and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

It may be clearly understood by a person skilled in the art that, for the purpose of convenient and brief description, for a detailed working process of the foregoing system, apparatus, and unit, refer to a corresponding process in the foregoing method embodiments, and details are not described herein again.

In the several embodiments provided in this application, it should be understood that the disclosed system, apparatus, and method may be implemented in other manners. For example, the described apparatus embodiment is merely an example. For example, the unit division is merely logical function division and may be other division in actual implementation. For example, a plurality of units or components may be combined or integrated into another system, or some features may be ignored or not performed. In addition, the displayed or discussed mutual couplings or direct couplings or communication connections may be implemented by using some interfaces. The indirect couplings or communication connections between the apparatuses or units may be implemented in electronic, mechanical, or other forms.

The units described as separate parts may or may not be physically separate, and parts displayed as units may or may not be physical units, may be located in one position, or may be distributed on a plurality of network units. Some or all of the units may be selected based on actual requirements to achieve the objectives of the solutions of the embodiments.

In addition, function units in the embodiments of this application may be integrated into one processing unit, or each of the units may exist alone physically, or two or more units are integrated into one unit.

When the functions are implemented in the form of a software function unit and sold or used as an independent product, the functions may be stored in a computer-readable storage medium. Based on such an understanding, the technical solutions of this application essentially, or the part contributing to the prior art, or some of the technical solutions may be implemented in a form of a software product. The computer software product is stored in a storage medium, and includes several instructions for instructing a computer device (which may be a personal computer, a server, or a network device) to perform all or some of the steps of the methods described in the embodiments of this application. The foregoing storage medium includes: any medium that can store program code, such as a USB flash drive, a removable hard disk, a read-only memory (ROM), a random access memory (RAM), a magnetic disk, or an optical disc.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

**Claims**

1. An electronic device, comprising a sensor and a control circuit, wherein

   the sensor is configured to: detect a force or a deformation of a shell, and output a force sensing signal $S_f$;
   the control circuit is configured to: receive the force sensing signal $S_f$ and determine, based on the force sensing signal $S_f$, whether to send a drive signal $S_d$ to the sensor, wherein the drive signal $S_d$ is used to drive the sensor to drive the shell to vibrate;

the sensor is further configured to: detect vibration of the shell and output a vibration sensing signal $S_z$; and

the control circuit is further configured to: receive the vibration sensing signal $S_z$, and determine, based on the vibration sensing signal $S_z$, whether to trigger an event.

2. The electronic device according to claim 1, wherein the control circuit is specifically configured to: detect and determine whether the force sensing signal $S_f$ satisfies an active action condition, and when the force sensing signal $S_f$ satisfies the active action condition, send the drive signal $S_d$ to the sensor.

3. The electronic device according to claim 2, wherein the control circuit is specifically configured to:

detect and determine whether the force sensing signal $S_f$ satisfies a condition for starting calculation, and when the force sensing signal $S_f$ satisfies the condition for starting calculation, calculate, based on the force sensing signal $S_f$, a force and/or an accelerating force sensed by the sensor; and

determine whether the force and/or the accelerating force satisfy/satisfies the active action condition, and when the force and/or the accelerating force satisfy/satisfies the active action condition, send the drive signal $S_d$ to the sensor.

4. The electronic device according to claim 2, wherein the control circuit is specifically configured to:

when the force sensing signal $S_f$ satisfies a condition for starting calculation, start an interrupt program; and

after the interrupt program is started, calculate, based on the force sensing signal $S_f$, a force and/or an accelerating force sensed by the sensor, and determine whether the force and/or the accelerating force satisfy/satisfies the active action condition, and when the force and/or the accelerating force satisfy/satisfies the active action condition, send the drive signal $S_d$ to the sensor.

5. The electronic device according to any one of claims 1 to 4, wherein the control circuit comprises a first amplification unit, and the first amplification unit is configured to amplify the vibration sensing signal $S_z$.

6. The electronic device according to any one of claims 1 to 5, wherein the control circuit further comprises a second amplification unit, configured to amplify the force sensing signal $S_f$.

7. The electronic device according to any one of claims 1 to 6, wherein the control circuit further comprises a filter unit, configured to filter the vibration sensing signal $S_z$.

8. The electronic device according to any one of claims 1 to 7, wherein the sensor comprises a first port A, a second port B, and a third port E, the first port A is configured to: receive the drive signal $S_d$ and output the force sensing signal $S_f$, the second port B is configured to output the vibration sensing signal $S_z$, and the third port E is a common end.

9. The electronic device according to any one of claims 1 to 7, wherein the sensor comprises a first port A, a second port B, and a third port E, the first port A is configured to receive the drive signal $S_d$, the second port B is configured to output the vibration sensing signal $S_z$ and the force sensing signal $S_f$, and the third port E is a common end.

10. The electronic device according to any one of claims 1 to 9, wherein the control circuit is a processing chip of the electronic device.

11. The electronic device according to any one of claims 1 to 9, wherein the control circuit is a control chip of the sensor.

12. The electronic device according to any one of claims 1 to 11, wherein the shell is a part of a housing of the electronic device.

13. The electronic device according to any one of claims 1 to 11, wherein the shell is a shell of the sensor.

14. A control circuit, wherein

the control circuit is configured to receive a force sensing signal $S_f$ output by a sensor, wherein the force sensing signal $S_f$ is used to indicate a force or a deformation detected by the sensor;

the control circuit is further configured to determine, based on the force sensing signal $S_f$, whether to send a drive signal $S_d$ to the sensor, wherein the drive signal $S_d$ is used to drive the sensor to vibrate; and the control circuit is further configured to: receive a vibration sensing signal $S_z$ sent by the sensor, and determine, based on the vibration sensing signal $S_z$, whether to trigger an event, wherein the vibration sensing signal $S_z$ is a response signal of the vibration.

15. The control circuit according to claim 14, wherein the control circuit is specifically configured to: detect and determine whether the force sensing signal $S_f$ satisfies an active action condition, and when the force sensing signal $S_f$ satisfies the active action condition, send the drive signal $S_d$ to the sensor.

16. The control circuit according to claim 15, wherein the control circuit is specifically configured to:

   detect and determine whether the force sensing signal $S_f$ satisfies a condition for starting calculation, and when the force sensing signal $S_f$ satisfies the condition for starting calculation, calculate, based on the force sensing signal $S_f$, a force and/or an accelerating force sensed by the sensor; and
   determine whether the force and/or the accelerating force satisfy/satisfies the active action condition, and when the force and/or the accelerating force satisfy/satisfies the active action condition, send the drive signal $S_d$ to the sensor.

17. The control circuit according to claim 15, wherein the control circuit is specifically configured to:

   when the force sensing signal $S_f$ satisfies a condition for starting calculation, start an interrupt program; and after the interrupt program is started, calculate, based on the force sensing signal $S_f$, a force and/or an accelerating force sensed by the sensor, and determine whether the force and/or the accelerating force satisfy/satisfies the active action condition, and when the force and/or the accelerating force satisfy/satisfies the active action condition, send the drive signal $S_d$ to the sensor.

18. The control circuit according to any one of claims 14 to 17, wherein the control circuit comprises a first amplification unit, and the first amplification unit is configured to amplify the vibration sensing signal $S_z$.

19. The control circuit according to any one of claims 14 to 18, wherein the control circuit further comprises a second amplification unit, configured to amplify the force sensing signal $S_f$.

20. The control circuit according to any one of claims 14 to 19, wherein the control circuit further comprises a filter unit, configured to filter the vibration sensing signal $S_z$.

21. The control circuit according to any one of claims 14 to 20, wherein the control circuit and the sensor are disposed in an electronic device, and the control circuit is located in a processing chip of the electronic device.

22. The electronic device according to any one of claims 14 to 20, wherein the control circuit is a control chip of the sensor.

23. A touch key assembly, comprising a sensor, a shell, and the control circuit according to any one of claims 14 to 22, wherein the sensor is configured to detect a force or a deformation of the shell, and a drive signal $S_d$ is used to drive the sensor to drive the shell to vibrate.

24. An electronic device, comprising the touch key assembly according to claim 23, wherein the shell and a housing of the electronic device are attached to each other or are integrated into an entire body.

FIG. 1

Frame

Sensitive region | Non-sensitive region

Deformation transfer | Force

Sensor

300

FIG. 2

200

Shell 10

Sensor 300

Control circuit
400

FIG. 3

11

10

300

FIG. 4(a)

11

10

12

300

FIG. 4(b)

200

Shell 10

Drive unit 61

Vibration sensing
unit 62

Sensor 300

Control circuit
400

FIG. 5

S1

10

300

S2

FIG. 6

FIG. 7

FIG. 8

<u>200</u>

Control circuit 400

$S_f$

Calculation unit 60

Signal generation unit 40

$S_d$

Detection unit 50

$S_z$

Sensor 300

Vibration sensing unit 62

Drive unit 61

Force sensing unit 63

FIG. 9

```
                    ┌─────────────────┐
                    │    Initialize   │
                    └─────────────────┘
                             │
                    ┌─────────────────┐
                    │      Start      │──────────────┐
                    └─────────────────┘              │
                             │                       │ No
                    ┌─────────────────┐              │
                    │ Passive calculation │          │
                    │ (force/accelerating force) │   │
                    └─────────────────┘              │ No
                             │                       │
                          ╱──────╲                   │
                        ╱  Is an active ╲             │
                      ╱   action         ╲───────────┤
                        ╲ condition satisfied? ╱      │
                          ╲──────╱                    │
                             │ Yes                    │
                    ┌─────────────────┐               │
                    │ Start active detection │        │
                    └─────────────────┘               │
                             │                        │
                          ╱──────╲                    │
                        ╱          ╲                  │
                      ╱ Trigger an event? ╲───────────┘
                        ╲          ╱
                          ╲──────╱
                             │ Yes
                    ┌─────────────────┐
                    │ Determine the event │
                    └─────────────────┘
```

FIG. 10

FIG. 11

200

Control circuit 400

$S_f$

| Calculation unit 60 | Second amplification unit 22 |

$S_d$

| Signal generation unit 40 |

| Detection unit 50 | First amplification unit 21 | Filter unit 25 |

$S_z$

Sensor 300

Vibration sensing unit 62

Drive unit 61

Force sensing unit 63

FIG. 12

200

500

AD2

$S_d$    300    $S_z$

I/O

A        B    C        AMP2

AMP1    $S_f$

E    R

AD1

22

25    21

FIG. 13

300

A    Input    Output    B

Common

E

FIG. 14

FIG. 15

Initialize

Start

Is a condition for starting
calculation satisfied?

No

No

No

Yes

Passive calculation
(force/accelerating force)

Is an active action
condition satisfied?

Yes

Start active detection

Trigger an event?

Yes

Determine the event

FIG. 16

200

Control circuit 400

| Interrupt unit 70 | Third amplification unit 23 |

$S_f$

| Calculation unit 60 | Second amplification unit 22 |

$S_f$

⊓⊔⊓⊔⊓⊔  $S_d$

Signal generation unit 40

$S_z$

| Detection unit 50 | First amplification unit 21 |

Sensor 300

Vibration sensing unit 62

Drive unit 61

Force sensing unit 63

FIG. 17

FIG. 18

```
┌─────────────────┐
│    Initialize   │
└─────────────────┘
         │
         ▼
┌─────────────────┐              No
│      Start      │◄──────────────────────┐
└─────────────────┘                       │
         │                        No       │
         ▼                                 │
    ╱─────────╲                           │
   ╱ Is an interrupt ╲      No            │
  ╱ condition satisfied? ╲────────────┐   │
   ╲                ╱                 │   │
    ╲─────────────╱                  │   │
         │ Yes                        │   │
         ▼                            │   │
┌─────────────────────┐              │   │
│  Passive calculation │              │   │ No
│(force/accelerating   │              │   │
│        force)        │              │   │
└─────────────────────┘              │   │
         │                            │   │
         ▼                            │   │
    ╱─────────╲                       │   │
   ╱ Is an active action ╲           │   │
  ╱ condition satisfied?  ╲──────────┘   │
   ╲                 ╱                    │
    ╲──────────────╱                      │
         │ Yes                            │
         ▼                                │
┌─────────────────────┐                  │
│ Start active detection│                 │
└─────────────────────┘                  │
         │                                │
         ▼                                │
    ╱─────────╲                           │
   ╱ Trigger an event? ╲─────────────────┘
   ╲               ╱
    ╲────────────╱
         │ Yes
         ▼
┌─────────────────────┐
│  Determine the event │
└─────────────────────┘
```

FIG. 19

FIG. 20

FIG. 21

200

500

AD1

I/O    $S_d$    300    $S_f$ or $S_z$    AMP1

A    B

E

21

FIG. 22

300

38

37

36    31 34 32    33    35    36

FIG. 23

300

78

73    76

77    74    75

72    77

71

FIG. 24

## INTERNATIONAL SEARCH REPORT

| | International application No. |
|---|---|
| | **PCT/CN2020/085273** |

**A. CLASSIFICATION OF SUBJECT MATTER**

G06F 3/01(2006.01)i; G06F 1/16(2006.01)i

According to International Patent Classification (IPC) or to both national classification and IPC

**B. FIELDS SEARCHED**

Minimum documentation searched (classification system followed by classification symbols)

G06F

Documentation searched other than minimum documentation to the extent that such documents are included in the fields searched

Electronic data base consulted during the international search (name of data base and, where practicable, search terms used)

WPI, EPODOC, CNPAT, CNKI: 触控, 触摸, 接触, 触发, 振动, 压, 震动, 力, 变形, 形变, 传感器, press+, force?, vibrat+, oscilliat+, touch+, tactile+

**C. DOCUMENTS CONSIDERED TO BE RELEVANT**

| Category* | Citation of document, with indication, where appropriate, of the relevant passages | Relevant to claim No. |
|---|---|---|
| PX | CN 110187757 A (HUAWEI TECHNOLOGIES CO., LTD.) 30 August 2019 (2019-08-30) claims 1-24, figures 1-24 | 1-24 |
| A | CN 105281740 A (VIVO COMMUNICATION TECHNOLOGY CO., LTD.) 27 January 2016 (2016-01-27) description, paragraphs [0021]-[0050], and figures 1-5 | 1-24 |
| A | CN 106321953 A (TOTO LTD.) 11 January 2017 (2017-01-11) entire document | 1-24 |
| A | CN 106155421 A (BOE TECHNOLOGY GROUP CO., LTD.) 23 November 2016 (2016-11-23) entire document | 1-24 |
| A | CN 105009052 A (AMAZON TECHNOLOGIES, INC.) 28 October 2015 (2015-10-28) entire document | 1-24 |
| A | JP 2004258851 A (CITIZEN WATCH CO., LTD.) 16 September 2004 (2004-09-16) entire document | 1-24 |

☐ Further documents are listed in the continuation of Box C.   ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **03 July 2020** | **15 July 2020** |

| Name and mailing address of the ISA/CN | Authorized officer |
|---|---|
| **China National Intellectual Property Administration (ISA/CN)** **No. 6, Xitucheng Road, Jimenqiao Haidian District, Beijing 100088 China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2020/085273**

| Patent document cited in search report | | | Publication date (day/month/year) | Patent family member(s) | | | Publication date (day/month/year) |
|---|---|---|---|---|---|---|---|
| CN | 110187757 | A | 30 August 2019 | None | | | |
| CN | 105281740 | A | 27 January 2016 | None | | | |
| CN | 106321953 | A | 11 January 2017 | EP | 3297165 | A1 | 21 March 2018 |
| | | | | EP | 3113365 | A2 | 04 January 2017 |
| | | | | EP | 3113365 | A3 | 12 April 2017 |
| | | | | CN | 106321953 | B | 06 September 2019 |
| | | | | US | 2017003253 | A1 | 05 January 2017 |
| | | | | EP | 3312995 | A1 | 25 April 2018 |
| | | | | US | 9958418 | B2 | 01 May 2018 |
| | | | | TW | I627364 | B | 21 June 2018 |
| | | | | SG | 10201605239 | A1 | 27 February 2017 |
| | | | | JP | 2017017677 | A | 19 January 2017 |
| | | | | TW | 201730696 | A | 01 September 2017 |
| CN | 106155421 | A | 23 November 2016 | CN | 106155421 | B | 26 November 2019 |
| CN | 105009052 | A | 28 October 2015 | US | 9035752 | B2 | 19 May 2015 |
| | | | | US | 2014253305 | A1 | 11 September 2014 |
| | | | | CN | 105009052 | B | 30 November 2018 |
| | | | | WO | 2014164190 | A1 | 09 October 2014 |
| | | | | EP | 2972712 | A1 | 20 January 2016 |
| | | | | US | 9791930 | B1 | 17 October 2017 |
| | | | | EP | 2972712 | A4 | 25 January 2017 |
| JP | 2004258851 | A | 16 September 2004 | None | | | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 201910340125